(19) Europäisches Patentamt
European Patent Office
Office européen des brevets

(11) EP 4 391 025 A1

(12) # EUROPEAN PATENT APPLICATION
published in accordance with Art. 153(4) EPC

(43) Date of publication:
**26.06.2024 Bulletin 2024/26**

(21) Application number: **22864506.5**

(22) Date of filing: **29.08.2022**

(51) International Patent Classification (IPC):
***H01L 21/312*** *(2006.01)* ***C08G 73/10*** *(2006.01)*

(52) Cooperative Patent Classification (CPC):
**C08G 73/10; H01L 21/31**

(86) International application number:
**PCT/JP2022/032439**

(87) International publication number:
**WO 2023/032924 (09.03.2023 Gazette 2023/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.09.2021 JP 2021144612**

(71) Applicant: **MITSUI CHEMICALS, INC.**
**Tokyo 104-0028 (JP)**

(72) Inventors:
- **KAYABA, Yasuhisa**
  **Sodegaura-shi, Chiba 299-0265 (JP)**
- **NAKAMURA, Yuzo**
  **Sodegaura-shi, Chiba 299-0265 (JP)**
- **KOZEKI, Takashi**
  **Sodegaura-shi, Chiba 299-0265 (JP)**

(74) Representative: **Hoffmann Eitle**
**Patent- und Rechtsanwälte PartmbB**
**Arabellastraße 30**
**81925 München (DE)**

(54) **COMPOSITION FOR FORMING FILM FOR SEMICONDUCTOR, LAMINATE, AND SUBSTRATE LAMINATE**

(57) A composition for forming a film for a semiconductor includes: an aliphatic diamine (A) that includes at least one of a primary amino group or a secondary amino group, and a main chain including a carbon atom, in which, in the aliphatic diamine (A), the total number of primary amino groups and secondary amino groups is 2 or greater, the number of carbon atoms of the main chain is from 2 to 180; and a cross-linking agent (D) that includes three or more - C(=O)OX groups in a molecule thereof (X representing a hydrogen atom or an alkyl group having from 1 to 6 carbon atoms), in which from one to six of the three or more -C(=O)OX groups are -C(=O)OH groups, and the cross-linking agent (D) has a weight average molecular weight of from 200 to 2000. Applications of the composition are also disclosed.

EP 4 391 025 A1

## Description

Technical Field

The present disclosure relates to a composition for forming a film for a semiconductor, a laminated body, and a substrate laminated body.

Background Art

As reduction in size and weight of electronic devices and improvement of performance thereof progresses, semiconductor chips and the like are desired to have higher integration. However, the desire is difficult to sufficiently address by means of miniaturization of circuits. In consideration of this, a method of high integration has been proposed in recent years, in which multiple semiconductor substrate (wafer) sheets are stacked in the thickness direction to form a multilayer three-dimensional structure. Proposed methods for stacking semiconductor substrates (wafers) include a method for direct joining of substrates, and a method using a joining material (for example, see Japanese Patent Application Laid-open (JP-A) No. H4-132258, Japanese Patent Application Laid-open (JP-A) No. 2010-226060, and Japanese Patent Application Laid-open (JP-A) No.2016-47895).

SUMMARY OF INVENTION

Problem to be Solved by Invention

In the case of using a joining material for joining semiconductor substrates together, a process may be envisaged which includes applying a resin to a surface of a semiconductor substrate, forming a joining layer therefrom by drying, heating or the like, and joining semiconductor substrates together via the joining layer. In this process, the semiconductor substrate having the joining layer thereon tends to warp, due to, for example, a difference between the thermal expansion coefficient of the joining layer and the thermal expansion coefficient of the semiconductor substrate. If the warpage generated is large, there would be a possibility that positional misalignment occurs during joining of semiconductor substrates.

In the case of using a joining material for joining semiconductor substrates together, if the joining layer formed from the joining material does not adhere tightly, there would be an increased possibility that semiconductor substrates separate after joining, or that a position misalignment between the semiconductor substrates is generated after joining.

In consideration of the foregoing issues, it is desirable that warping of a substrate is reduced in the case of forming a joining layer on a substrate, such as a semiconductor substrate, by using a composition for forming a film for a semiconductor, and that the joining strength between the substrates is high.

One aspect of the present invention has been formulated in consideration of the foregoing, and aims to provide: a composition for forming a film for a semiconductor, wherein the composition is capable of forming a joining layer that can reduce warpage of a substrate when the joining layer is formed on the substrate and provides a high joining strength between substrates; and a laminated body and a substrate laminated body that are formed using that the composition for forming a film for a semiconductor.

Means for Solving Problem

Specific means for solving the problem include the following.

<1> A composition for forming a film for a semiconductor, including:

an aliphatic diamine (A) that includes at least one of a primary amino group or a secondary amino group, and a main chain including a carbon atom, wherein, in the aliphatic diamine (A), the total number of primary amino groups and secondary amino groups is 2 or greater, the number of carbon atoms of the main chain is from 2 to 180, and the aliphatic diamine (A) has a weight average molecular weight of from 60 to 2000; and

a cross-linking agent (D) that includes three or more -C(=O)OX groups in a molecule thereof (X representing a hydrogen atom or an alkyl group having from 1 to 6 carbon atoms), wherein from one to six of the three or more -C(=O)OX groups are -C(=O)OH groups, and the cross-linking agent (D) has a weight average molecular weight of from 200 to 2000.

<2> The composition for forming a film for a semiconductor according to <1>, further including a silane compound (B) that includes at least one of a primary amino group or a secondary amino group, and one or more silicon atoms,

wherein, in the silane compound (B), the one or more silicon atoms and one or more non-polar groups, if any, bonded to the one or more silicon atoms satisfy a relationship, (non-polar groups)/Si < 1.8, as a molar ratio.

<3> The composition for forming a film for a semiconductor according to <2>, wherein the weight average molecular weight of the silane compound (B) is from 130 to 10000.

<4> The composition for forming a film for a semiconductor according to any one of <1> to <3>, further including a siloxane compound (C) that is linear and includes at least one of a primary amino group or a secondary amino group, silicon atoms, and non-polar groups bonded to the silicon atoms, wherein, in the siloxane compound (C), the total number of primary amino groups and secondary amino groups is 2 or greater, and the silicon atoms and the non-polar groups bonded to the silicon atoms satisfy a relationship, (non-polar groups)/Si ≥ 1.8, as a molar ratio.

<5> The composition for forming a film for a semiconductor according to <4>, wherein the weight average molecular weight of the siloxane compound (C) is from 200 to 2000.

<6> The composition for forming a film for a semiconductor according to any one of <1> to <5>, wherein the aliphatic diamine (A) does not include a cyclic structure.

<7> The composition for forming a film for a semiconductor according to any one of <1> to <6>, wherein amino group-containing components / cross-linking agent (D), which is the ratio of the content of the cross-linking agent (D) to the total content of components having an amino group contained in the composition for forming a film for a semiconductor, is greater than or equal to 0.1 and less than or equal to 10 as a molar ratio.

<8> The composition for forming a film for a semiconductor according to any one of <1> to <7>, wherein COOX / amino groups, which is the ratio of the number of -C(=O)OX groups in molecules of the cross-linking agent (D) to the total number of amino groups of molecules of components having an amino group contained in the composition for forming a film for a semiconductor, is greater than or equal to 0.1 and less than or equal to 5.0.

<9> The composition for forming a film for a semiconductor according to any one of <1> to <8>, wherein at least one X in the three or more -C(=O)OX groups in the cross-linking agent (D) is an alkyl group having from 1 to 6 carbon atoms.

<10> The composition for forming a film for a semiconductor according to any one of <1> to <9>, wherein both ends of the main chain of the aliphatic diamine (A) are each independently a primary amino group or a secondary amino group.

<11> A laminated body, including a joining layer formed from the composition for forming a film for a semiconductor according to any one of <1> to <10>, and a substrate, which are layered one on the other.

<12> A substrate laminated body, including a first substrate, a joining layer formed from the composition for forming a film for a semiconductor according to any one of <1> to <10>, and a second substrate, which are layered in this order.

<13> A substrate laminated body, including:

a first stacked-layer region including a first substrate, a joining layer formed from the composition for forming a film for a semiconductor according to any one of <1> to <10>, and a second substrate, which are layered in this order; and

a second stacked-layer region including a first substrate, an electrode, and a second substrate, which are layered in this order,

wherein at least one of the first stacked-layer region and at least one of the second stacked-layer region are arranged in a plane direction that is orthogonal to the layer-stacking direction.

<14> The substrate laminated body according to <13>, wherein two or more sets each consisting of the first stacked-layer region are stacked in the layer-stacking direction, and two or more sets each consisting of the second stacked-layer region are stacked in the layer-stacking direction.

<15> The substrate laminated body according to any one of <12> to <14>, wherein at least one of the first substrate or the second substrate is a semiconductor substrate that includes at least one element selected from the group consisting of Si, Ga, Ge, and As. Advantageous Effect of Invention

According to an aspect of the present invention, it is possible to provide a composition for forming a film for a semiconductor, wherein the composition is capable of forming a joining layer that can reduce warpage of a substrate when the joining layer is formed on the substrate and provides a high joining strength between substrates; and a laminated body and a substrate laminated body that are formed using that the composition for forming a film for a semiconductor.

MODES FOR CARRYING OUT INVENTION

In the present disclosure, any numerical range expressed using "to" means a range including numerical values described before and after "to" as the lower limit value and the upper limit value.

For numerical ranges described in a stepwise manner in the present disclosure, the upper limit value or the

lower limit value of one numerical range may be replaced with the upper limit value or the lower limit value of another numerical range in the stepwise description. The upper limit value or the lower limit value of any numerical range described in the present disclosure may also be replaced with a value described in an Example.

In the present disclosure, the term "substrate laminated body" refers to a laminated body having a structure in which two substrates are joined together via a joining layer formed using the method of producing a substrate laminated body according to the present disclosure. The substrate laminated body may include three or more substrates, and may have a structure in which two of the three or more substrates are joined via a joining layer formed using the method of producing a substrate laminated body according to the present disclosure.

[Composition for Forming Film for Semiconductor]

A composition for forming a film for a semiconductor according to the present disclosure includes:

an aliphatic diamine (A) that includes at least one of a primary amino group or a secondary amino group, and a main chain including a carbon atom, wherein, in the aliphatic diamine (A), the total number of primary amino groups and secondary amino groups is 2 or greater, the number of carbon atoms of the main chain is from 2 to 180, and the aliphatic diamine (A) has a weight average molecular weight of from 60 to 2000 (hereinafter also referred to simply as "aliphatic diamine (A)"); and

a cross-linking agent (D) that includes three or more -C(=O)OX groups in a molecule thereof (X representing a hydrogen atom or an alkyl group having from 1 to 6 carbon atoms), wherein from one to six of the three or more -C(=O)OX groups are -C(=O)OH groups, and the cross-linking agent (D) has a weight average molecular weight of from 200 to 2000 (hereinafter also referred to simply as "cross-linking agent (D)").

The composition for forming a film for a semiconductor according to the present disclosure includes the aliphatic diamine (A) and the cross-linking agent (D) described above. Due to this, when a joining layer is formed on a substrate, such as a semiconductor substrate, from the composition for forming a film for a semiconductor by applying the composition for forming a film for a semiconductor to the substrate, warping of a substrate can be reduced, and, moreover, the joining strength between the substrates is high. Due to this, reduction of positional misalignment at the time of joining the substrates together can be reduced, for example.

(Aliphatic Diamine (A))

The composition for forming a film for a semiconductor according to the present disclosure includes an aliphatic diamine (A) that includes at least one of a primary amino group or a secondary amino group, and a main chain including a carbon atom, wherein, in the aliphatic diamine (A), the total number of primary amino groups and secondary amino groups is 2 or greater, the number of carbon atoms of the main chain is from 2 to 180, and the aliphatic diamine (A) has a weight average molecular weight of from 60 to 2000.

Due to the aliphatic diamine (A) having a main chain of which the number of carbon atoms is from 2 to 180, and having a weight average molecular weight of from 60 to 2000, the aliphatic diamine (A) contributes to formation of a flexible skeleton in a joining layer formed through reaction with the after-mentioned cross-linking agent (D), which improves the flexibility of the joining layer and thereby favorably reducing warping of the substrate.

In the present disclosure, the aliphatic diamine (A) is not limited to a compound of which the main chain is composed only of carbon atoms, and may have a configuration in which some of the carbon atoms of the main chain have been each replaced by a divalent or higher-valent atom such as an oxygen or a sulfur atom or by a functional group such as a carbonyl group, a secondary amino group, a tertiary amino group, an amido group, or an ester group.

An amino group that is contained in the aliphatic diamine (A) and that is a primary amino group or a secondary amino group is hereinafter also referred to as a "specific amino group". Examples of the aliphatic diamine (A) containing a specific amino group include a compound that contains two or more primary amino groups but contains no secondary amino group, a compound that contains no primary amino group but contains two or more secondary amino groups, and a compound that contains at least one primary amino group and at least one secondary amino group.

The aliphatic diamine (A) preferably contains two or more specific amino groups in the main chain thereof, more preferably contains two specific amino groups in the main chain thereof, and still more preferably has a structure in which both ends of the main chain of the aliphatic diamine (A) are each independently a primary amino group or a secondary amino group, and particularly preferably has a primary amino group at both ends of the main chain of the aliphatic diamine (A), from the viewpoints of reducing an increase in the density of cross-linking formed through reaction with the after-mentioned cross-linking agent (D) and favorably forming a joining layer that has a flexible skeleton favorably contributing to reduction of warping of the substrate.

The aliphatic diamine (A) preferably has two amino groups in the main chain thereof. The number of specific

amino groups in side chains of the aliphatic diamine (A) is preferably 1 or fewer, and it is preferable that no specific amino groups are contained in side chains of aliphatic diamine (A), from the viewpoint of favorably forming a joining layer that has a flexible skeleton favorably contributing to reduction of warping of the substrate.

The number of carbon atoms of the main chain of the aliphatic diamine (A) is preferably 3 or more, more preferably 5 or more, and still more preferably 6 or more, from the viewpoint of more favorably forming a joining layer having a flexible skeleton. The number of carbon atoms of the main chain of the aliphatic diamine (A) is preferably 100 or less, more preferably 50 or less, and still more preferably 20 or less, from the viewpoint of obtaining a joining layer having high thickness uniformity.

It is preferable that the aliphatic diamine (A) does not include a cyclic structure. When the aliphatic diamine (A) does not include a cyclic structure such as a non-aromatic carbocycle, an aromatic ring, or a heterocyclic ring (heterocycle), a joining layer having a flexible skeleton can favorably be formed, and warpage of the substrate can more favorably be reduced.

The weight average molecular weight of the aliphatic diamine (A) may be, for example, from 60 to 2000. The weight average molecular weight is preferably greater than or equal to 80, more preferably greater than or equal to 100, and still more preferably greater than or equal to 130, from the viewpoint of more favorably forming a joining layer having a flexible skeleton. The weight average molecular weight is preferably smaller than or equal to 1000, more preferably smaller than or equal to 500, and still more preferably smaller than or equal to 300, from the viewpoint of obtaining a joining layer having high thickness uniformity.

In the present disclosure, the weight average molecular weight refers to a polyethyleneglycol-equivalent weight average molecular weight as measured using the gel permeation chromatography (GPC) method. Specifically, the weight average molecular weight is obtained by detecting refractive index in a measurement carried out at a flow rate of 1.0 mL/min using 0.1 mol/L sodium nitrate aqueous solution as a developing solvent and using an analysis apparatus SHODEX DET RI-101 and two types of analysis columns (TSKgel G6000PWXL-CP and TSKgel G3000PWXL-CP manufactured by Tosoh Corporation), and calculating the weight average molecular weight using an analysis software (EMPOWER3 manufactured by Waters), with polyethylene glycol / polyethylene oxide serving as reference samples.

The aliphatic diamine (A) is preferably a compound which contains a primary amino group at both ends of the main chain thereof and in which the main chain has a structure in which a carbon chain or part of a carbon chain has been replaced by an atom other than a carbon atom or by a functional group.

Examples of the atom other than a carbon atom include an oxygen atom and a sulfur atom.

Examples of the functional group for replacement of part of a carbon chain include a carbonyl group, a secondary amino group, a tertiary amino group, an amido group, and an ester group.

Examples of the aliphatic diamine (A) include a compound having a main chain formed of a carbon chain, such as trimethylene diamine, tetramethylene diamine, hexamethylene diamine, heptamethylene diamine, octamethylene diamine, nonamethylene diamine, decamethylene diamine, undecamethylene diamine, dodecamethylene diamine, 2,4,4-trimethylhexamethylene diamine, or 3-methylpentamethylene diamine, and a compound having a main chain in which part of a carbon chain has been replaced by an atom other than a carbon atom or by a functional group, such as diethylene triamine, triethylene tetramine, tetraethylene pentamine, 3,3'-diaminodipropylamine, or 1,2-bis(2-aminoethoxy)ethane.

The aliphatic diamine (A) may be used singly, or in combination of two or more thereof.

Aliphatic diamine (A) / components having an amino group, which is the ratio of the content of the aliphatic diamine (A) to the total content of components having an amino group contained in the composition for forming a film for a semiconductor may be greater than or equal to 0.05 in terms of a molar ratio, or may be greater than or equal to 0.2 in terms of a molar ratio, or may be greater than or equal to 0.5 in terms of a molar ratio. When the ratio, aliphatic diamine (A) / components having an amino group, is greater than or equal to 0.1, the flexibility of the joining layer more improves, thereby enabling more favorable reduction of warpage of the substrate.

The upper limit of the ratio, aliphatic diamine (A) / components having an amino group, is not particularly limited as long as the ratio is less than or equal to 1.0, and the ratio may be less than or equal to 0.8.

In the present disclosure, the component having an amino group refers to a component that includes a least one of a primary amino group or a secondary amino group that can react with the cross-linking agent (D). As the component having an amino group, only the aliphatic diamine (A) may be included, or the aliphatic diamine (A) and at least one of the after-mentioned silane compound (B) or the after-mentioned siloxane compound (C) may be included in combination, or the aliphatic diamine (A) and at least one of the silane compound (B), the siloxane compound (C) or the after-mentioned other amino group-containing component may be included in combination, for example.

(Silane Compound (B))

The composition for forming a film for a semiconductor according to the present disclosure includes a silane compound (B) that includes at least one of a primary amino group or a secondary amino group, and one or more silicon

atoms, wherein, in the silane compound (B), the one or more silicon atoms and one or more non-polar groups, if any, bonded to the one or more silicon atoms satisfy a relationship, (non-polar groups)/Si < 1.8, as a molar ratio (hereinafter also simply referred to as "silane compound (B)"). When the composition for forming a film for a semiconductor to which the silane compound (B) is incorporated is used, a joining layer having excellent heat resistance can be formed due to the high glass transition temperature being high.

That the one or more silicon atoms contained in the silane compound (B) and one or more non-polar groups, if any, bonded to the one or more silicon atoms satisfy a relationship, (non-polar groups)/Si < 1.8, as a molar ratio means that the ratio of the number of non-polar groups bonded to silicon atom(s) to the number of the silicon atom(s) satisfies the relationship, (non-polar groups)/Si < 1.8.

Further, that the silane compound (B) satisfies the relationship, (non-polar groups)/Si < 1.8, indicates that the amount of non-polar group(s) bonded to the silicon atom(s) is smaller than the predetermined amount. Due to this, a structure derived from the silane compound (B) contributes to heat resistance in the joining layer that is formed through reaction with the after-mentioned cross-linking agent (D).

The silane compound (B) includes at least one of a primary amino group ($-NH_2$ group) or a secondary amino group (for example, $-NHR^a$ group in which $R^a$ represents an alkyl group).

The total number of primary amino groups and secondary amino groups in the silane compound (B) is not particularly limited as far as the total number is 1 or greater. For example, the total number of primary amino groups and secondary amino groups is preferably 1 or 2, and more preferably 1, from the viewpoint of curbing an increase in cross-linking density caused by reaction with the after-mentioned cross-linking agent (D).

The silane compound (B) may include or may not include a tertiary amino group (for example, $-NR^bR^c$ group in which each of $R^b$ and $R^c$ independently represents an alkyl group) , which is an amino group other than primary and secondary amino groups.

The number of silicon atoms in the silane compound (B) is not particularly limited as far as the number is 1 or greater. The number of silicon atoms in the silane compound (B) may be, for example, 1 or 2, and may be 1.

The weight average molecular weight of the silane compound (B) is preferably from 130 to 10,000, more preferably from 130 to 5000, and still more preferably from 130 to 2000.

In the silane compound (B), the one or more silicon atoms and one or more non-polar groups, if any, bonded to the one or more silicon atoms satisfy a relationship, (non-polar groups)/Si < 1.8, as a molar ratio. Here, examples of the non-polar group(s) bonded to the silicon atom(s) are the same as those of the non-polar groups in the siloxane compound (C).

In the silane compound (B), it is preferable that (non-polar groups)/Si ≤ 1.5 is satisfied, and it is more preferable that (non-polar groups)/Si ≤ 1.0 is satisfied, from the viewpoint of further improving the heat resistance.

The lower limit of (non-polar groups)/Si is not particularly limited, and for example, (non-polar groups)/Si ≥ 0 may be satisfied. It is preferable that (non-polar groups)/Si ≥ 0.5 is satisfied, and it is more preferable that (non-polar groups)/Si ≥ 0.8 is satisfied, in order to stabilize the composition and to make the composition less easily gelate.

In the silane compound (B), it is preferable that a polar group is bonded to a silicon atom, from the viewpoint of improving heat resistance. The presence of a polar group bonded to a silicon atom enables a siloxane bond (-Si-O-Si) to be formed through, for example, hydrolysis or dehydration condensation at the polar group, and the increased cross-linking property of the film can improve heat resistance (glass transition temperature). The polar group may be a functional group that can be converted into a hydroxy group through hydrolysis, and specific examples of the polar group include a hydroxy group, and an $C_1$-$C_5$ alkoxy group such as a methoxy group or an ethoxy group. The siloxane bond (-Si-O-Si) is classified into neither a polar group bonded to a silicon atom of the silane compound (B) nor a non-polar group bonded to a silicon atom of the silane compound (B).

The silane compound (B) may be, for example, a compound represented by the following Formula (B-1).

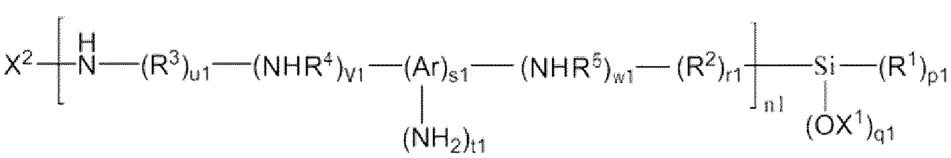

(B-1)

In Formula (B-1), $R^1$ represents an optionally substituted alkyl group having from 1 to 4 carbon atoms. Each of $R^2$ and $R^3$ independently represents an optionally substituted alkylene group having from 1 to 12 carbon atoms, an ether group, or a carbonyl group. The optionally substituted alkylene group having from 1 to 12 carbon atoms may further include a carbonyl group, an ether group, or the like in the skeleton thereof. Each of $R^4$ and $R^5$ independently represents an optionally substituted alkylene group having from 1 to 4 carbon atoms or a single bond. Ar represents a divalent or trivalent aromatic ring. $X^1$ represents a hydrogen or an optionally substituted alkyl group having from 1 to 5 carbon atoms. $X^2$ represents a hydrogen, a cycloalkyl group, a heterocyclic group, an aryl group, or an optionally substituted alkyl group

having from 1 to 5 carbon atoms, and the optionally substituted alkyl group having from 1 to 5 carbon atoms may further include a carbonyl group, an ether group, or the like in the skeleton thereof. When any of $R^1$, $R^2$, $R^3$, $R^4$, $R^5$, or $X^1$ is present in plurality, the plural $R^1$'s, $R^2$'s, $R^3$'s, $R^4$'s, $R^5$'s, or $X^1$'s may be the same as or different from each other.

In Formula (B-1), p1 represents 0 or 1, and q1 represent 2 or 3, provided that p1+q1=3 is satisfied. Further, n1 represents an integer from 1 to 3, and each of r1, s1, t1, u1, V1, and w1 independently represents 0 or 1.

In Formula (B-1), a substituent for an alkyl group or an alkylene group of any of $R^1$, $R^2$, $R^3$, $R^4$, $R^5$, $X^1$, or $X^2$ may be each independently selected, for example, from an amino group, a hydroxy group, an alkoxy group, a cyano group, a carboxylic acid group, a sulfonic acid group, or a halogen.

The divalent or trivalent aromatic ring of Ar is, for example, a divalent or trivalent benzene ring. Examples of the aryl group of $X^2$ include a phenyl group, a methylbenzyl group, and a vinylbenzyl group.

Further, n1 is preferably 1 or 2, and more preferably 1. Moreover, each of s1, t1, V1, and w1 is preferably 0.

Specific examples of the silane compound (B) include N-(2-aminoethyl)-3-aminopropyl methyl diethoxysilane, N-(2-aminoethyl)-3-aminopropyl triethoxysilane, N-(2-aminoethyl)-3-aminoisobutyl methyl dimethoxysilane, N-(2-aminoethyl)-11-aminoundecyl trimethoxysilane, 3-aminopropyl trimethoxysilane, 3-aminopropyl triethoxysilane, N-phenyl-3-aminopropyl trimethoxysilane, (aminoethylaminoethyl)phenyl triethoxysilane, methylbenzylaminoethylaminopropyl trimethoxysilane, benzylaminoethylaminopropyl triethoxysilane, 3-ureidopropyl triethoxysilane, (aminoethylaminoethyl)phenethyl trimethoxysilane, (aminoethylaminomethyl)phenethyl trimethoxysilane, N-[2-[3-(trimethoxysilyl)propylamino]ethyl] ethylenediamine, 3-aminopropyl diethoxy methylsilane, 3-aminopropyl dimethoxy methylsilane, trimethoxy [2-(2-aminoethyl)-3-aminopropyl] silane, diaminomethyl methyl diethoxysilane, methylaminomethyl methyl diethoxysilane, p-aminophenyl trimethoxysilane, N-methylaminopropyl triethoxysilane, N-methylaminopropyl methyl diethoxysilane, (phenylaminomethyl)methyl diethoxysilane, acetoamidopropyl trimethoxysilane, N,N-bis[3-(trimethoxysilyl)propyl] ethylenediamine, N,N'-bis[3-(trimethoxysilyl)propyl] ethylenediamine, bis[(3-triethoxysilyl)propyl]amine, pyperazinylpropyl methyl dimethoxysilane, bis[3-(triethoxysilyl)propyl] urea, bis(methyldiethoxysilylpropyl)amine, 2,2-dimethoxy-1,6-diaza-2-sila cyclooctane, 3,5-diamino-N-(4-(triethoxysilyl)phenyl)benzamide, and hydrolysates thereof; 3-aminopropyl dihydroxy methylsilane, 3-aminopropyl trihydroxysilane, and N-2-(aminoethyl)-3-aminopropyl trihydroxysilane.

The silane compound (B) may be used singly, or in combination of two or more thereof.

The silane compound (B) may be, for example, a polymer that includes a branched siloxane structure, a polymer that includes a cyclic siloxane structure, or a polymer that includes a cage-type siloxane structure. The cage-type siloxane structure is represented, for example, by the following Formula (X).

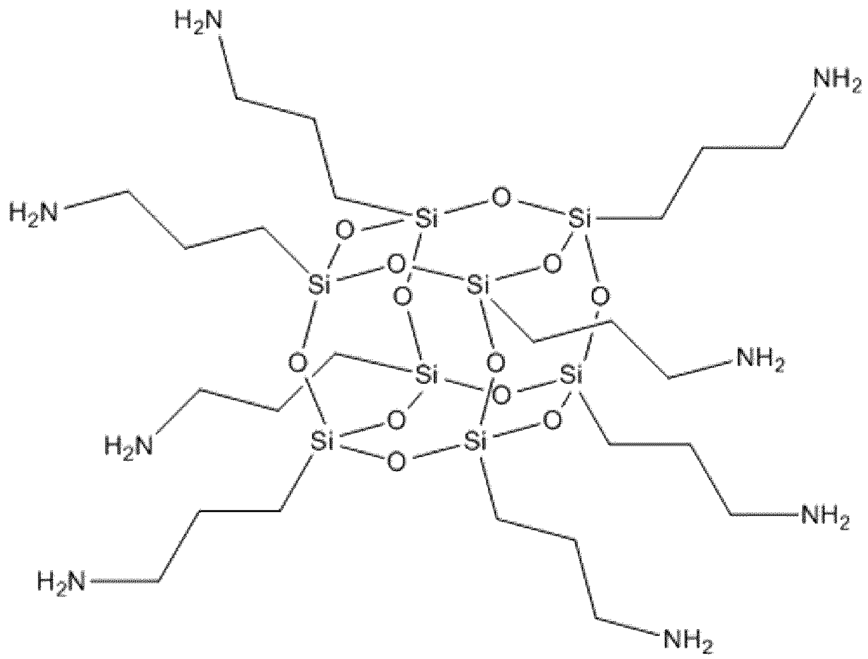

(X)

(Siloxane Compound (C))

The composition for forming a film for a semiconductor according to the present disclosure preferably includes a siloxane compound (C) that is linear and includes at least one of a primary amino group or a secondary amino group, silicon atoms, and non-polar groups bonded to the silicon atoms, wherein, in the siloxane compound (C), the total number of primary amino groups and secondary amino groups is 2 or greater, and the silicon atoms and the non-polar groups

bonded to the silicon atoms satisfy a relationship, (non-polar groups)/Si ≥ 1.8, as a molar ratio (hereinafter referred to simply as "siloxane compound (C)").

That the silicon atoms and the non-polar groups bonded to the silicon atoms satisfy a relationship, (non-polar groups)/Si ≥ 1.8, as a molar ratio indicates that the ratio of the number of non-polar groups bonded to the silicon atoms to the number of the silicon atoms satisfy the relationship, (non-polar groups)/Si ≥ 1.8.

In the present disclosure, the siloxane compound being linear means that siloxane bonds (Si-O-Si bonds) are present in a straight chain arrangement while none of a branched siloxane structure, a circular siloxane structure, or a cage-type siloxane structure is included in the compound.

Due to the siloxane compound (C) being a linear siloxane compound, the siloxane compound (C) contributes to formation of a flexible skeleton in the joining layer formed through reaction with the after-mentioned cross-linking agent (D), and improves the flexibility of the joining layer, thereby more favorably reducing the warping of the substrate.

Further, that the siloxane compound (C) satisfies the relationship, (non-polar groups)/Si ≥ 1.8, indicates that the non-polar groups bonded to the silicon atoms are present in an amount that is greater than or equal to the predetermined amount. Due to this, the non-polar groups contribute to reduction in the cross-linking density in the joining layer formed through reaction with the after-mentioned cross-linking agent (D), and improves the flexibility of the joining layer, thereby more favorably reducing the warping of the substrate.

The siloxane compound (C) includes at least one of a primary amino group ($-NH_2$ group) or a secondary amino group (for example, $-NHR^a$ group in which $R^a$ represents an alkyl group), and the total number of primary amino groups and secondary amino groups is 2 or greater. In the siloxane compound (C), the total number of primary amino groups and secondary amino groups is preferably from 2 to 4, more preferably 2 or 3, and still more preferably 2.

The siloxane compound (C) may include or may not include a tertiary amino group (for example, $-NR^bR^c$ group in which each of $R^b$ and $R^c$ independently represents an alkyl group) , which is an amino group other than primary and secondary amino groups.

The weight average molecular weight of the siloxane compound (C) is, for example, greater than or equal to 200 and less than or equal to 2000. With respect to the lower limit value, the weight average molecular weight is preferably greater than or equal to 200, more preferably greater than or equal to 230, and still more preferably greater than or equal to 240, from the viewpoint of facilitating achievement of a more flexible structure. With respect to the upper limit value, the weight average molecular weight is preferably less than or equal to 1500, more preferably less than or equal to 1000, and still more preferably less than or equal to 800, from the viewpoint of facilitating formation of a coating film using the composition.

In the siloxane compound (C), the silicon atoms and the non-polar groups bonded to the silicon atoms satisfy a relationship, (non-polar groups)/Si ≥ 1.8, as a molar ratio. Here, examples of the non-polar groups bonded to the silicon atoms include an alkyl group, an aryl group, and an aralkyl group. A methyl group, an ethyl group, a propyl group, and the like are preferable as an alkyl group, a phenyl group and the like are preferable as an aryl group, and a benzyl group and the like are preferable as an aralkyl group.

In the present disclosure, structures in which a part of a non-polar group such as an alkyl group, an aryl group or an aralkyl group is replaced with a hydrophilic group such as a hydroxy group or an amino group are not classified into non-polar groups. A siloxane bond (-Si-O-Si) is classified into neither a polar group bonded to a silicon atom in the silane compound (B) nor a non-polar group bonded to a silicon atom in the silane compound (B).

The siloxane compound (C) preferably satisfies (non-polar groups)/Si ≥ 2.0, from the standpoint that the nonpolar groups contributes to a decrease in the cross-linking density in the joining layer formed through a reaction with the after-mentioned cross-linking agent (D), thereby more favorably reducing the warping of the substrate.

The upper limit of the (non-polar groups)/Si may be specified as, for example, (non-polar groups)/Si ≤ 2.5, or as (non-polar groups)/Si ≤ 2.0.

In an example, the equation, (non-polar groups)/Si = 2.0, may be satisfied.

An amino group that is contained in the siloxane compound (C) and that is a primary amino group or a secondary amino group is hereinafter also referred to as a "specific amino group". Examples of the siloxane compound (C) containing a specific amino group include a compound that contains two or more primary amino groups but contains no secondary amino group, a compound that contains no primary amino group but contains two or more secondary amino groups, and a compound that contains at least one primary amino group and at least one secondary amino group.

The siloxane compound (C) preferably contains two or more specific amino groups in the main chain thereof, more preferably contains two specific amino groups in the main chain thereof, and still more preferably has a structure in which both ends of the main chain of the siloxane compound (C) are each independently a primary amino group or a secondary amino group, and particularly preferably has a primary amino group at both ends of the main chain of the siloxane compound (C), from the viewpoints of reducing an increase in the density of cross-linking formed through reaction with the after-mentioned cross-linking agent (D) and favorably forming a joining layer that has a flexible skeleton favorably contributing to reduction of warping of the substrate.

The siloxane compound (C) preferably has two amino groups in the main chain thereof. The number of specific

amino groups in side chains is preferably 1 or fewer, and it is preferable that no specific amino groups are contained in side chains, from the viewpoint of favorably forming a joining layer that has a flexible skeleton favorably contributing to reduction of warping of the substrate.

The siloxane compound (C) may be, for example, a compound represented by the following Formula (C-1).

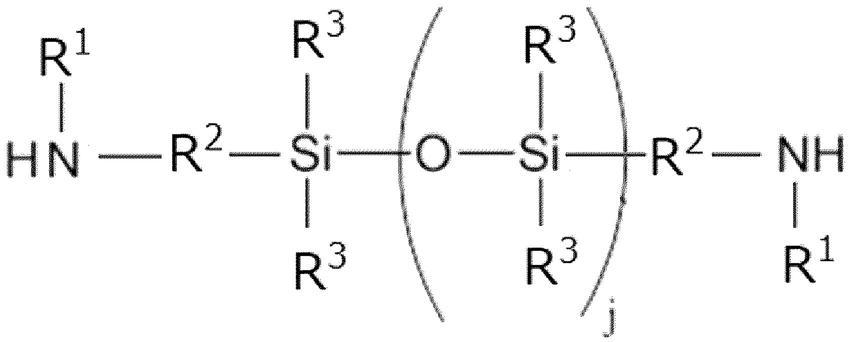

**(C-1)**

In Formula (C-1), each $R^1$ independently represents a hydrogen or an optionally substituted alkyl group, each $R^2$ independently represents a divalent linking group, each $R^3$ independently represents a non-polar group, and j represents an integer from 1 to 10.

A substituent on an alkyl group of $R^1$ may be each independently selected from, for example, a hydroxy group, an alkoxy group, a cyano group, a carboxylic acid group, a sulfonic acid group, or a halogen.

In Formula (C-1), $R^1$ is preferably a hydrogen atom.

In Formula (C-1), a divalent linking group of $R^2$ may be each independently selected, for example, from: an alkylene group; a divalent linking group obtained by replacing a hydrogen atom in an alkylene group by another atom or functional group; or a divalent linking group obtained by replacing a methylene group in an alkylene group by -NH-. The number of carbon atoms in the divalent linking group is preferably, for example, from 1 to 20, preferably from 2 to 10, and more preferably from 3 to 5.

In Formula (C-1), a non-polar group of $R^3$ may be each independently selected, for example, from an alkyl group, an aryl group, or an aralkyl group. As an alkyl group, a methyl group, an ethyl group, a propyl group, and the like are preferable. As an aryl group, a phenyl group and the like are preferable. As an aralkyl group, a benzyl group and the like are preferable.

In Formula (C-1), j is greater than or equal to 1 and less than or equal to 10. With respect to the lower limit for j, j is preferably greater than or equal to 1 from the viewpoint of favorably forming a joining layer that has a flexible skeleton favorably contributing to reduction of warping of the substrate. With respect to the upper limit value for j, j is preferably less than or equal to 10, more preferably less than or equal to 5, and still more preferably less than or equal to 3, from the viewpoint of facilitating formation of a uniform coating film having reduced phase separation.

In the siloxane compound (C), the number of atoms in the longest straight chain (except for atoms in side chains and hydrogen atoms) is preferably greater than or equal to 7 and less than or equal to 50, from the viewpoint of favorably forming a joining layer having a flexible skeleton favorably contributing to reduction of warpage of the substrate. The number of atoms in the longest straight chain (except for hydrogen atoms) is preferably greater than or equal to 8, and more preferably greater than or equal to 10, from the viewpoint of favorably forming a joining layer that has a flexible skeleton favorably contributing to reduction of warping of the substrate. With respect to the upper limit of the number of atoms in the longest straight chain (except for hydrogen atoms), the number of atoms is preferably less than or equal to 30, and more preferably less than or equal to 20, from the viewpoint of facilitating formation of a uniform coating film having reduced phase separation.

In the case of Formula (C-1), the longest straight chain when $R^1$ is an alkyl group is the number of atoms in $R^1$-N-$R^2$-Si-$(O-Si)_j$-$R^2$-N-$R^1$, and the longest straight chain when $R^1$ is a hydrogen atom is the number of atoms in N-$R^2$-Si-$(O-Si)_j$-$R^2$-N.

The siloxane compound (C) may be, for example, a compound represented by the following Formula (C-2).

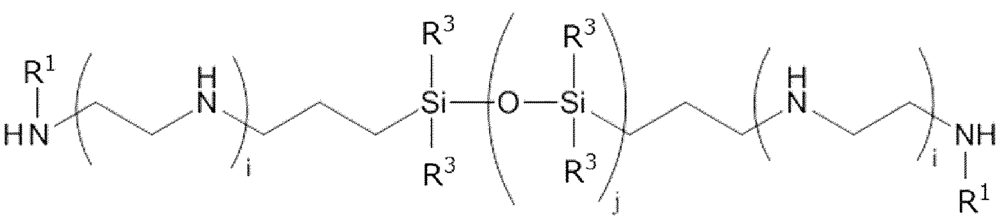

**(C-2)**

In Formula (C-2), each $R^1$ independently represents a hydrogen or an optionally substituted alkyl group, each $R^3$ independently represents a non-polar group, i represents an integer from 0 to 4, and j represents an integer from 1 to 10.
In Formula (C-2), each i independently represents preferably an integer from 0 to 2, more preferably 0 or 1, and still more preferably 0.
Preferable modes of $R^1$, $R^3$ and j in Formula (C-2) are the same as preferable modes of $R^1$, $R^3$ and j in Formula (C-1).
Examples of the siloxane compound (C) include 1, 3-bis(3-aminopropyl) tetramethyl disiloxane (corresponding to Formula (C-2) in which $R^1$ is a hydrogen atom, $R^3$ is a methyl group, i=0, and j=1), and 1,3-bis(2-aminoethylamino)propyl tetramethyl disiloxane (corresponding to Formula (C-2) in which $R^1$ is a hydrogen atom, $R^3$ is a methyl group, i=1, and j=1).
The siloxane compound (C) may be used singly, or in combination of two or more thereof.
In a case in which the composition for forming a film for a semiconductor according to the present disclosure includes the silane compound (B) and the siloxane compound (C), the ratio of the siloxane compound (C) to the silane compound (B) is preferably greater than or equal to 0.01 in terms of molar ratio, more preferably greater than or equal to 0.1 in terms of molar ratio, and still more preferably greater than or equal to 0.2 in terms of molar ratio, from the viewpoint of reduction of warpage. Further, from the viewpoint of joining strength, the ratio of the siloxane compound (C) to the silane compound (B) is preferably less than or equal to 10 in terms of molar ratio, and more preferably less than or equal to 5 in terms of molar ratio.
In a case in which the composition for forming a film for a semiconductor according to the present disclosure includes the silane compound (B) and the siloxane compound (C), the ratio of the siloxane compound (C) to the silane compound (B) is preferably less than or equal to 1 in terms of molar ratio, preferably less than or equal to 0.5 in terms of molar ratio, more preferably less than or equal to 0.1 in terms of molar ratio, and still more preferably 0 in terms of molar ratio, from another viewpoint such as facilitating reduction of blemish on apparatuses during preparation of a semiconductor film.

(Cross-linking Agent (D))

The composition for forming a film for a semiconductor according to the present disclosure includes a cross-linking agent (D) that includes three or more -C(=O)OX groups in a molecule thereof (X representing a hydrogen atom or an alkyl group having from 1 to 6 carbon atoms), wherein from one to six of the three or more -C(=O)OX groups (hereinafter also referred to as "COOX") are -C(=O)OH groups (hereinafter also referred to as "COOH"), and the cross-linking agent (D) has a weight average molecular weight of from 200 to 2000.
The cross-linking agent (D) is specified to be a compound that includes three or more -C(=O)OX groups in a molecule thereof (X representing a hydrogen atom or an alkyl group having from 1 to 6 carbon atoms), from the standpoint that a film having high smoothness and having reduced aggregates and pits can be obtained upon film forming by applying the composition according to the present disclosure to a member. The cross-linking agent (D) may be a compound that includes from three to six -C(=O)OX groups in a molecule thereof, or a compound that includes three or four -C(=O)OX groups in a molecule thereof. From the viewpoint of enhancing heat resistance, the cross-linking agent (D) is preferably a compound that includes from four to six -C(=O)OX groups in a molecule thereof. The cross-linking agent (D) is preferably a compound that includes four -C(=O)OX groups in a molecule thereof, from the viewpoint of decreasing the moisture absorption amount and decreasing the outgassing amount.
In the cross-linking agent (D), examples of X in a -C(=O)OX group include a hydrogen atom and alkyl groups having from 1 to 6 carbon atoms, among which a hydrogen atom, a methyl group, an ethyl group, and a propyl group are preferable. The *X*'s in - C(=O)OX groups may be the same as each other or different from each other.
The cross-linking agent (D) may be a compound that includes from one to six -C(=O)OH groups, which corresponds to a case in which X is a hydrogen atom, in a molecule thereof. The cross-linking agent (D) is preferably a compound that includes from one to four -C(=O)OH groups in a molecule thereof, more preferably a compound that includes from two to four -C(=O)OH groups in a molecule thereof, and still more preferably a compound that includes two or three -C(=O)OH groups in a molecule thereof.
The cross-linking agent (D) is a compound having a weight average molecular weight of from 200 to 2000. The weight average molecular weight of the cross-linking agent (D) is preferably from 200 to 1000, more preferably from 200 to 600, and still more preferably from 200 to 400.
The cross-linking agent (D) preferably includes a cyclic structure in a molecule thereof. Examples of the cyclic structure include an alicyclic structure and an aromatic cyclic structure. The cross-linking agent (D) may include plural cyclic structures in a molecule thereof, in which case the plural cyclic structures may be the same as or different from each other.
Examples of the alicyclic structure include an alicyclic structure having from 3 to 8 carbon atoms, preferably an alicyclic structure having from 4 to 6 carbon atoms. Inside of the cyclic structure may be either saturated or unsaturated. More specifically, examples of the alicyclic structure include a saturated alicyclic structure such as a cyclopropane ring,

a cyclobutane ring, a cyclopentane ring, a cyclohexane ring, a cycloheptane ring, or a cyclooctane ring, and an unsaturated alicyclic structure such as a cyclopropene ring, a cyclobutene ring, a cyclopentene ring, a cyclohexene ring, a cycloheptene ring, or a cyclooctene ring.

The aromatic cyclic structure is not particularly limited as long as the cyclic structure is aromatic. Examples thereof include a benzenic aromatic rings such as a benzene ring, a naphthalene ring, an anthracene ring, or a perylene ring, an aromatic heterocycle such as a pyridine ring or a thiophene ring, and a non-benzenic aromatic ring such as an indene ring or an azulene ring.

A cyclic structure contained in a molecule of the cross-linking agent (D) is preferably, for example, at least one selected from the group consisting of a cyclobutane ring, a cyclopentane ring, a cyclohexane ring, a benzene ring, and a naphthalene ring. From the viewpoint of further enhancing the heat resistance of the joining layer obtained from the composition for forming a film for a semiconductor, the cyclic structure is preferably at least one of a benzene ring or a naphthalene ring.

As described above, the cross-linking agent (D) may include plural cyclic structures in a molecule thereof. In a case in which the cyclic structure is a benzene ring, the cross-linking agent (D) may include a biphenyl structure, a benzophenone structure, a diphenyl ether structure, or the like.

The cross-linking agent (D) preferably includes a fluorine atom in a molecule thereof, more preferably includes from one to six fluorine atoms in a molecule thereof, and still more preferably includes from three to six fluorine atoms in a molecule thereof. For example, the cross-linking agent (D) may include a fluoroalkyl group in a molecule thereof, particularly a trifluoroalkyl group or a hexafluoroisopropyl group.

Examples of the cross-linking agent (D) further include: carboxylic acid compounds such as alicyclic carboxylic acids, benzene carboxylic acids, naphthalene carboxylic acids, diphthalic acid, and fluorinated aromatic carboxylic acids; and carboxylic acid ester compounds such as alicyclic carboxylic acid esters, benzene carboxylic acid esters, naphthalene carboxylic acid esters, diphthalic acid esters, and fluorinated aromatic carboxylic acid esters. A carboxylic acid ester compound is a compound that includes a carboxy group (-C(=O)OH group) in a molecule thereof in which at least one X among the three or more - C(=O)OX groups is an alkyl group having from 1 to 6 carbon atoms (i.e., includes an ester bond). When the cross-linking agent (D) is a carboxylic acid ester compound in the composition for forming a film for a semiconductor according to the present disclosure, aggregations in the composition due to association of the aliphatic diamine (A) and optionally contained components such as the silane compound (B) and the siloxane compound (C), with the cross-linking agent (D) is reduced, as a result of which aggregations and pits are reduced, and formation of a joining layer having excellent smoothness, adjustment of the thickness of the joining layer, and the like tend to be facilitated.

The carboxylic acid compound is preferably a tetravalent or lower-valent carboxylic acid compound having four or fewer -C(=O)OH groups, and is more preferably a trivalent or tetravalent carboxylic acid compound that includes three or four -C(=O)OH groups.

The carboxylic acid ester compound is preferably a compound that includes from one to three carboxy groups (-C(=O)OH groups) and includes from one to three ester bonds in a molecule thereof, and more preferably a compound that includes one or two carboxy groups and includes one or two ester bonds in a molecule thereof.

In a case in which *X*'s in three or more -C(=O)OX groups are alkyl groups having from 1 to 6 carbon atoms in the carboxylic acid ester compound, each of the *X*'s is preferably a methyl group, an ethyl group, a propyl group, a butyl group, or the like; from the viewpoint of further reducing aggregations due to association of the aliphatic diamine (A) and optionally contained components such as the silane compound (B) and the siloxane compound (C), with the cross-linking agent (D), each of the *X*'s is more preferably an ethyl group or a propyl group .

Specific examples of the carboxylic acid compound include, but are not limited to; alicyclic carboxylic acids such as 1,2,3,4-cyclobutanetetracarboxylic acid, 1,2,3,4-cyclopentanetetracarboxylic acid, 1,3,5-cyclohexanetricarboxylic acid, 1,2,4-cyclohexanetricarboxylic acid, 1,2,4,5-cyclohexanetetracarboxylic acid, 1,2,3,4,5,6-cyclohexanehexacarboxylic acid; benzen carboxylic acids such as 1,2,4-benzenetricarboxylic acid, 1,3,5-benzenetricarboxylic acid, pyromellitic acid, 3,4'-biphthalic acid, P-phenylenebis(trimellitic acid), benzenepentacarboxylic acid, and mellitic acid; naphthalene carboxylic acids such as 1,4,5,8-naphthalenetetracarboxylic acid, 2,3,6,7-naphthalenetetracarboxylic acid; diphthalic acids such as 3,3',5,5'-tetracarboxydiphenylmethane, biphenyl-3,3',5,5'-tetracarboxylic acid, biphenyl-3,4',5-tricarboxylic acid, biphenyl-3,3',4,4'-tetracarboxylic acid, benzophenone-3,3',4,4'-tetracarboxylic acid, 4,4'-oxydiphthalic acid, 3,4'-oxydiphthalic acid, 1,3-bis(phthalic acid) tetramethyl disiloxane, 4,4'-(ethyne-1,2-diyl)diphthalic acid, 4,4'-(1,4-phenylenebis(oxy))diphthalic acid, 4,4'-([1,1'-biphenyl]-4,4'-diylbis(oxy))diphthalic acid, and 4,4'-((oxybis(4,1-phenylene))bis(oxy))diphthalic acid; perylene carboxylic acids such as perylene-3,4,9,10-tetracarboxylic acid; anthracene carboxylic acids such as anthracene-2,3,6,7-tetracarboxylic acid; and fluorinated aromatic ring carboxylic acids such as 4,4'-(hexafluoroisopropylidene)diphthalic acid, 9,9-bis(trifluoromethyl)-9H-xanthene-2,3,6,7-tetracarboxylic acid, and 1,4-ditrifluoromethyl pyromellitic acid.

A specific example of the carboxylic acid ester compound is a compound in which at least one carboxy group of any of the above-described specific examples of the carboxylic acid compound has been replaced by an ester group.

Examples of the carboxylic acid ester compound include half-esterified compounds represented by the following Formulae (D-1) to (D-5).

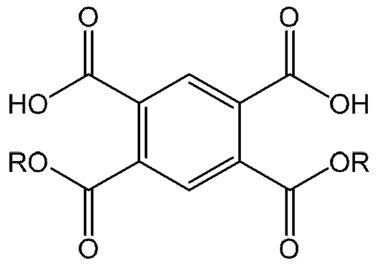

(D-1)

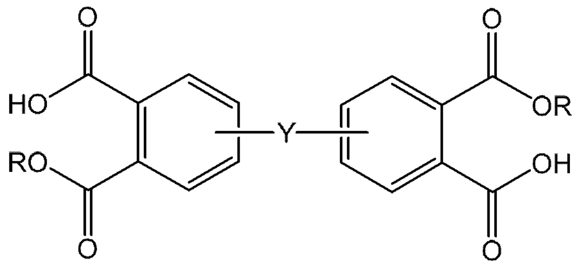

(D-2)

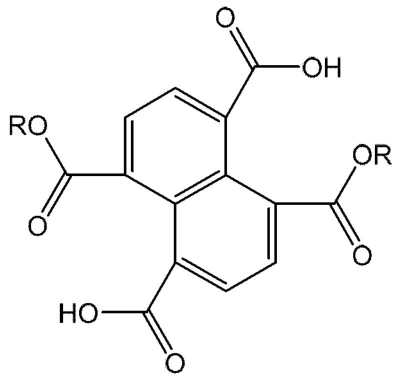

(D-3)

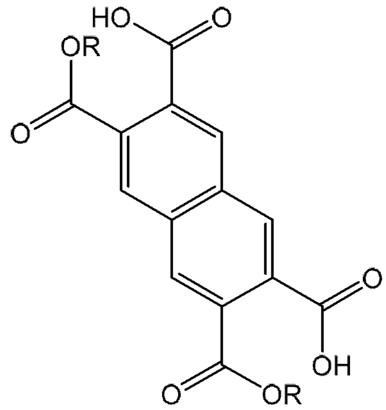

(D-4)

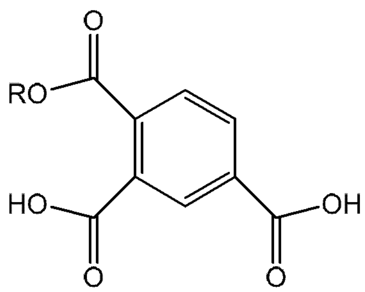

(D-5)

In Formulae (D-1) to (D-5), R is an alkyl group having from 1 to 6 carbon atoms. In particular, a methyl group, an ethyl group, a propyl group, and a butyl group are preferable, and an ethyl group and a propyl group are more preferable.

In Formula (D-2), Y is a single bond, O, C=O, or $C(CF_3)_2$.

The carboxylic acid ester compound is preferably a half-esterified compound represented by Formula (C-2), and more preferably a half-esterified compound in which Y in Formula (C-2) is O, from the viewpoint of facilitating formation of a film for a semiconductor that has a more smooth surface.

The half-esterified compound can be produced, for example, by mixing a carboxylic acid anhydride, which is an anhydride of the carboxylic acid compound described above, with an alcohol solvent, thereby causing ring-opening of the carboxylic acid anhydride.

Amino group-containing components / cross-linking agent (D), which is the ratio of the content of the cross-linking agent (D) to the total content of components having an amino group contained in the composition for forming a film for a semiconductor is not particularly limited. For example, from the viewpoints of reducing gelation of the composition and from the stand point of the balance of cross-linking reaction, amino group-containing components / cross-linking agent (D) is preferably greater than or equal to 0.1 and less than or equal to 10 in terms of molar ratio, more preferably greater than or equal to 0.2 and less than or equal to 5 in terms of molar ratio, and still more preferably greater than or equal to 0.4 and less than or equal to 2.5 in terms of molar ratio.

COOH / amino groups, which is the ratio of the number of -C(=O)OH groups in the cross-linking agent (D) molecules to the total number of amino groups of molecules of components having an amino group contained in the composition for forming a film for a semiconductor, is preferably from 0.3 to 3.0, and more preferably from 0.5 to 2.0,

from the viewpoint of reducing gelation of the composition.

Here, each amino group in COOH / amino groups refers to an amino group that can react with a -C(=O)OH group, and refers to at least one of a primary amino group or a secondary amino group.

COOX / amino groups, which is the ratio of the number of -C(=O)OX groups in the cross-linking agent (D) molecules to the total number of amino groups of molecules of components having an amino group contained in the composition for forming a film for a semiconductor, is preferably greater than or equal to 0.1 and less than or equal to 5.0, more preferably greater than or equal to 0.1 and less than or equal to 3.0, still more preferably greater than or equal to 0.3 and less than or equal to 2.5, and particularly preferably greater than or equal to 0.4 and less than or equal to 2.2. When COOX / amino groups is greater than or equal to 0.1 and less than or equal to 5.0, a joining layer having a cross-linking structure such as an amide, amideimide, or imide between the cross-linking agent (D) and a component having an amino group such as the aliphatic diamine (A), and having more improved heat resistance and electrically insulating properties can be favorably formed after heating treatment of the composition for forming a film for a semiconductor.

Here, each amino group in COOX / amino groups refers to an amino group that can react with a -C(=O)OH group, and refers to at least one of a primary amino group or a secondary amino group.

(Other Amino Group-Containing Component)

The composition for forming a film for a semiconductor according to the present disclosure may include another amino group-containing component, which is a component containing an amino group, as a component other than the aliphatic diamine (A), the silane compound (B), the siloxane compound (C) and the cross-linking agent (D).

Examples of the other amino group-containing component include an acyclic aliphatic amine other than the aliphatic diamine (A) described above, and a cyclic amine.

Examples of the acyclic aliphatic amine other than the aliphatic diamine (A) include an aliphatic amine having a weight average molecular weight of from 10,000 to 400,000.

The aliphatic amine having a weight average molecular weight of from 10,000 to 400,000 preferably contains at least one of a primary amino group or a secondary amino group. Specific examples of the aliphatic amine having a weight average molecular weight of from 10,000 to 400,000 include a polyalkylene imine, which is a polymer of an alkylene imine such as ethylene imine, propylene imine, butylene imine, pentylene imine, hexylene imine, heptylene imine, octylene imine, trimethylene imine, tetramethylene imine, pentamethylene imine, hexamethylene imine, or octamethylene imine; a polyallyl amine; and a polyacrylamide.

The polyethyleneimine (PEI) can be produced by known methods described, for example, in Japanese Patent Publication (JP-B) No. S43-8828, Japanese Patent Publication (JP-B) No. 49-33120, Japanese Patent Application Laid-open (JP-A) No. 2001-2123958, and International Publication (WO) No. 2010/137711 pamphlet. Polyalkyleneimines other than polyethyleneimine can be produced in a manner similar to that in the case of polyethyleneimine.

It is also preferable that the aliphatic amine having a weight average molecular weight of from 10,000 to 400,000 is a derivative of the polyalkyleneimine described above (polyalkyleneimine derivative; particularly preferably a polyethyleneimine derivative). The polyalkyleneimine derivative is not particularly limited as long as the derivative is a compound that can be produced using the polyalkyleneimine. Specific examples thereof include a polyalkyleneimine derivative obtained by introducing an alkyl group (preferably an alkyl group having from 1 to 10 carbon atoms) or an aryl group into a polyalkyleneimine, and a polyalkyleneimine derivative obtained by introducing a cross-linkable group such as a hydroxy group into a polyalkyleneimine.

These polyalkyleneimine derivatives can be produced by ordinary methods using the polyalkyleneimine. Specifically, the polyalkyleneimine derivative may be produced according to the method described in, for example, Japanese Patent Application Laid-open (JP-A) No. H6-016809.

Examples of the cyclic amine other than the aliphatic amine (A) include an alicyclic amine, an aromatic amine, and a hetero ring (heterocyclic) amine, other than the aliphatic amine (A). The cyclic amine may include plural cyclic structures in a molecule thereof, in which case the plural cyclic structures may be the same as or different from each other. The cyclic amine is preferably an aromatic amine since use of an aromatic amine makes it easier to obtain a compound having higher thermal stability.

The cyclic amine is preferably an amine compound that includes a cyclic structure in a molecule thereof and has a weight average molecular weight of from 90 to 600.

Examples of the alicyclic amine other than the aliphatic amine (A) include cyclohexylamine and dimethylaminocyclohexane.

Examples of the aromatic amine include diaminodiphenyl ether, xylene diamines such as paraxylene diamine, diaminobenzene, diaminotoluene, methylene dianiline, dimethyldiaminobiphenyl, bis(trifluoromethyl)diaminobiphenyl, diaminobenzophenone, diaminobenzanilide, bis(aminophenyl)fluorene, bis(aminophenoxy)benzene, bis(aminophenoxy)biphenyl, dicarboxy diaminodiphenylmethane, diaminoresorcin, dihydroxybenzidine, diaminobenzidine, 1,3,5-triaminophenoxybenzene, 2,2'-dimethylbenzidine, and tris(4-aminophenyl)amine.

Examples of the heterocyclic ring of the heterocyclic amine include a heterocyclic ring that contains a sulfur atom as a heteroatom (for example, a thiophene ring), and a heterocyclic ring that contains a nitrogen atom as a heteroatom (for example, a five-membered ring such as a pyrrole ring, a pyrrolidine ring, a pyrazole ring, an imidazole ring, or a triazole ring, a six-membered ring such as an isocyanuric ring, a pyridine ring, a pyridazine ring, a pyrimidine ring, a pyrazine ring, a piperidine ring, a piperazine ring, or a triazine ring, or a condensed ring such as an indole ring, an indoline ring, a quinoline ring, an acridine ring, a naphthylidine ring, a quinazoline ring, a purine ring, or a quinoxaline ring).

For example, examples of a heterocyclic amine that contains a nitrogen-containing heterocyclic ring include melamine, Ammeline, Melame, Meleme, and tris(4-aminophenyl)amine.

Examples of an amine compound that contains both a heterocyclic ring and an aromatic ring include N2,N4,N6-tris(4-aminophenyl)-1,3,5-triazine-2,4,6-triamine.

In the composition for forming a film for a semiconductor according to the present disclosure, other amino group-containing components / aliphatic diamine (A), or other amino group-containing components / [aliphatic diamine (A), silane compound (B), and siloxane compound (C)], which is the molar ratio of other amino group-containing components to the aliphatic diamine (A) or to the aliphatic diamine (A), the silane compound (B), and the siloxane compound (C), may be, for example, from 0 to 0.5, or may be from 0 to 0.3, or may be from 0 to 0.1.

(Polar Solvent (E))

The composition for forming a film for a semiconductor according to the present disclosure may include a polar solvent (E). Here, a polar solvent (E) refers to a solvent having a relative permittivity of 5 or higher at room temperature. Specific examples of the polar solvent (E) include: a protonic inorganic compound such as water or deuterated water; an alcohol such as methanol, ethanol, 1-propanol, 2-propanol, 1-butanol, 2-butanol, isobutyl alcohol, isopentyl alcohol, cyclohexanol, ethyleneglycol, propyleneglycol, 2-methoxyethanol, 2-ethoxyethanol, benzylalcohol, diethyleneglycol, triethyleneglycol, or glycerine; an ether such as tetrahydrofuran or dimethoxyethane; an aldehyde or ketone such as furfural, acetone, ethyl methyl ketone or cyclohexane; an acid derivative such as acetic anhydride, ethyl acetate, butyl acetate, ethylene carbonate, propylene carbonate, formaldehyde, N-methylformamide, N,N-dimethylformamide, N-methylacetoamide, N,N-dimethylacetoamide, N-methyl-2-pyrrolidone, or hexamethylphosphoric amide; a nitrile such as acetonitrile or propionitrile; a nitro compound such as nitromethane or nitrobenzene; and a sulfur compound such as dimethylsulfoxide. As the polar solvent (E), it is preferable that a protonic solvent is contained, it is more preferable that water is contained, and it is still more preferable that ultrapure water is contained.

The content of the polar solvent (E) in the composition for forming a film for a semiconductor is not particularly limited, and may be, for example, from 1.0% by mass to 99.99896% by mass with respect to the entire composition, or may be from 40% by mass to 99.99896% by mass with respect to the entire composition.

The boiling point of the polar solvent (E) is preferably 150 °C or lower, more preferably 120 °C or lower, from the viewpoint of evaporating the polar solvent (E) during drying for forming a joining layer to reduce the amount of residual solvent in the joining layer.

(Additive (F))

The composition for forming a film for a semiconductor according to the present disclosure may include an additive (F), besides the aliphatic diamine (A), the silane compound (B), the siloxane compound (C), the cross-linking agent (D), and the polar solvent (E). Examples of the additive (F) include an acid (F-1) that contains a carboxy group and has a weight average molecular weight of from 46 to 195, and a base (F-2) that contains a nitrogen atom and has a weight average molecular weight of from 17 to 120.

The acid (F-1) is an acid that contains a carboxy group and has a weight average molecular weight of from 46 to 195. We surmise that when the composition for forming a film for a semiconductor according to the present disclosure includes the acid (F-1) as an additive (F), an amino group of the aliphatic diamine (A) or an optionally contained component such as the silane compound (B) or the siloxane compound (C) and a carboxy group of the acid (F-1) form an ionic bond, thereby reducing aggregation caused by association of the aliphatic diamine (A) and optionally contained components such as the silane compound (B) and the siloxane compound (C), with the cross-linking agent (D). More specifically, we surmise that the aggregation is reduced because an interaction (for example, an electrostatic interaction) between an ammonium ion derived from an amino group of the aliphatic diamine (A) or an optionally contained component such as the silane compound (B) or the siloxane compound (C) and a carboxylate ion derived from a carboxy group of the acid (F-1) is stronger than an interaction between an ammonium ion derived from an amino group of the aliphatic diamine (A) or an optionally contained component such as the silane compound (B) or the siloxane compound (C) and a carboxylate ion derived from a carboxy group of the cross-linking agent (D). However, each aspect disclosed in relation to the present invention is by no means limited by the foregoing surmise.

The acid (F-1) is not particularly limited as far as the acid is a compound that contains a carboxy group and has a weight average molecular weight of from 46 to 195. Examples thereof include a monocarboxylic acid compound, a dicarboxylic acid compound, and an oxydicarboxylic acid compound. More specifically, examples of the acid (F-1) include formic acid, acetic acid, malonic acid, oxalic acid, citric acid, benzoic acid, lactic acid, glycolic acid, glyceric acid, butyric acid, methoxyacetic acid, ethoxyacetic acid, phthalic acid, terephthalic acid, picolinic acid, salicylic acid, and 3,4,5-trohydroxybenzoic acid.

In the present disclosure, the content of the acid (F-1) in the composition for forming a film for a semiconductor is not particularly limited. For example, the ratio (COOH / amino groups) of the number of carboxy groups of the acid (F-1) molecules to the total number of amino groups of molecules of amino-group containing components is preferably greater than or equal to 0.01 and less than or equal to 10, more preferably greater than or equal to 0.02 and less than or equal to 6, and still more preferably greater than or equal to 0.5 and less than or equal to 3.

The base (F-2) is a base that contains a nitrogen atom and has a weight average molecular weight of from 17 to 120. We surmise that when the composition for forming a film for a semiconductor according to the present disclosure includes the base (F-2) as an additive (F), a carboxy group of the cross-linking agent (D) and an amino group of the base (F-2) form an ionic bond, thereby reducing aggregation caused by association of the aliphatic diamine (A) and optionally contained components such as the silane compound (B) and the siloxane compound (C), with the cross-linking agent (D). More specifically, we surmise that the aggregation is reduced because an interaction between a carboxylate ion derived from a carboxy group of the cross-linking agent (D) and an ammonium ion derived from an amino group of the base (F-2) is stronger than an interaction between an ammonium ion derived from an amino group of the aliphatic diamine (A) or an optionally contained components such as the silane compound (B) or the siloxane compound (C) and a carboxylate ion derived from a carboxy group of the cross-linking agent (D). However, each aspect disclosed in relation to the present invention is by no means limited by the foregoing surmise.

The base (F-2) is not particularly limited as far as the base is a compound that contains a nitrogen atom and has a weight average molecular weight of from 17 to 120. Examples thereof include a monoamine compound and a diamine compound. More specifically, examples of the base (F-2) include ammonia, ethylamine, ethanolamine, diethylamine, triethylamine, ethylenediamine, N-acetylethylenediamine, N-(2-aminoethyl)ethanolamine, and N-(2-aminoethyl)glycine.

In the present disclosure, the content of the base (F-2) in the composition for forming a film for a semiconductor is not particularly limited. For example, the ratio (N/COOH) of the number of nitrogen atoms of the base (F-2) molecules to the number of carboxy groups of the cross-linking agent (D) molecules is preferably greater than or equal to 0.5 and less than or equal to 5, and more preferably greater than or equal to 0.9 and less than or equal to 3.

In a case in which the joining layer of the substrate laminated body according to the present disclosure is desired to have electrically insulating properties, the composition for forming a film for a semiconductor according to the present disclosure may include a compound such as tetraethoxysilane, tetramethoxysilane, bistriethoxysilylethane, bistriethoxysilylmethane, bis(methyl diethoxysilyl)ethane, 1,1,3,3,5,5-hexaethoxy-1,3,5-trisilacyclohexane, 1,3,5,7-tetramethyl-1,3,5,7-tetrahydroxylcyclosiloxane, 1,1,4,4-tetramethyl-1,4-diethoxydisilethylene, or 1,3,5-trimethyl-1,3,5-trimethyl-1,3,5-triethoxy-1,3,5-trisilacyclohexane, from the viewpoint of improvement of electrically insulating properties or mechanical strength. The composition for forming a film for a semiconductor according to the present disclosure may include a compound such as methy triethoxysilane, dimethyl diethoxysilane, or trimethyl ethoxysilane, for improving the hydrophobicity of the joining layer having electrically insulating properties. The composition for forming a film for a semiconductor according to the present disclosure may include such a compound, for the purpose of controlling the etching selectivity.

The composition for forming a film for a semiconductor according to the present disclosure may include a solvent other than the polar solvent (E). Examples of such a solvent include normal hexane.

The composition for forming a film for a semiconductor according to the present disclosure may include phthalic acid, benzoic acid, or a derivative thereof, in order to improve electrical properties.

The composition for forming a film for a semiconductor according to the present disclosure may include benzotriazole or a derivative thereof in order to, for example, reduce corrosion of copper.

The pH of the composition for forming a film for a semiconductor according to the present disclosure is not particularly limited, and is preferably from 2.0 to 12.0.

<Method of Producing Composition for Forming Film for Semiconductor>

A method of producing a composition for forming a film for a semiconductor according to the present disclosure is described below. The method of producing a composition for forming a film for a semiconductor according to the present disclosure includes a mixing step of mixing the aliphatic diamine (A) and the cross-linking agent (D). In the mixing step, the silane compound (B), the siloxane compound (C), the polar solvent (E), the additive (F), and the like may also be mixed therewith. The timing for adding the respective components in the mixing step is not particularly limited.

In the method for producing a composition for forming a film for a semiconductor according to the present disclosure, at least one additive (F) selected from the group consisting of an acid (F-1) that contains a carboxy group and has a weight average molecular weight of from 46 to 195 and a base (F-2) that contains a nitrogen atom and has a weight average molecular weight of from 17 to 120 may be added to the aliphatic diamine (A), the optionally contained silane compound (B) or siloxane compound (C) (hereinafter also referred to as "aliphatic diamine (A) + relevant optional components") or the cross-linking agent (D) in the mixing step. The timing for adding the additive (F) is not particularly limited.

In a case in which the acid (F-1) is added as an additive (F), the mixing step is preferably a step of mixing a mixture of the acid (F-1) and the aliphatic diamine (A) + relevant optional components, with the cross-linking agent (D). In other words, it is preferable that the aliphatic diamine (A) + relevant optional components and the acid (F-1) are mixed in advance to the mixing of the aliphatic diamine (A) + relevant optional components and the cross-linking agent (D). This enables favorably reducing white clouding and gelation of the composition (for example, gelation is not preferable since it may necessitate a long time to convert the composition to a transparent state) at the time of mixing the aliphatic diamine (A) + relevant optional components and the cross-linking agent (D).

In a case in which the base (F-2) is added as an additive (F), the mixing step is preferably a step of mixing a mixture of the base (F-2) and the cross-linking agent (D) with the aliphatic diamine (A) + relevant optional components. In other words, it is preferable that the cross-linking agent (D) and the base (F-2) are mixed in advance to the mixing of the aliphatic diamine (A) + relevant optional components with the cross-linking agent (D). This enables favorably reducing white clouding and gelation of the composition (for example, gelation is not preferable since it may necessitate a long time to convert the composition to a transparent state) at the time of mixing the aliphatic diamine (A) + relevant optional components and the cross-linking agent (D).

[Laminated Body]

The laminated body according to the present disclosure includes a joining layer formed from the composition for forming a film for a semiconductor according to the present disclosure and a substrate, which are layered one on the other. In the laminated body according to the present disclosure, the above-described composition for forming a film for a semiconductor is used for forming a joining layer. Due to this, warpage of the substrate is reduced in the laminated body according to the present disclosure.

The laminated body according to the present disclosure is used, for example, for joining the substrate included in the laminated body to another member such as another substrate, via the joining layer.

(Substrate)

The material of the substrate is not particularly limited, and may be made of a material that is ordinarily used as a semiconductor substrate or the like.

The substrate preferably includes at least one element selected from the group consisting of Si, Al, Ti, Zr, Hf, Fe, Ni, Cu, Ag, Au, Ga, Ge, Sn, Pd, As, Pt, Mg, In, Ta, and Nb. Examples of the material of the substrate include a semiconductor: Si, InP, GaN, GaAs, InGaAs, InGaAlAs, SiC, an oxide, a carbide, a nitride: a borosilicate glass (PYREX (registered trademark)), quarts glass(SiOz), sapphire, $ZrO_2$, $Si_3N_4$, AlN, a piezoelectric material, a dielectric material: $BaTiO_3$, $LiNbO_3$, $SrTiO_3$, diamond, a metal: Al, Ti, Fe, Cu, Ag, Au, Pt, Pd, Ta, and Nb.

Examples of the material of the substrate also include polydimethylsiloxane (PDMS), an epoxy resin, a phenol resin, a polyimide, a benzocyclobutene resin, and a polybenzoxazole.

The substrate may have a multilayer structure. Examples thereof include: a structure in which an inorganic layer of silicon oxide, silicon nitride, SiCN (silicon carbonitride) or the like is formed on a surface of a silicon substrate or the like; a structure in which an organic layer of a polyimide resin, a polybenzoxazole resin, an epoxy resin, a benzocyclobutene resin such as CYCLOTENE (registered trademark), or the like is formed on a surface of a silicon substrate or the like; and a structure in which a composite material of an inorganic material and an organic material is formed on a silicon substrate.

The use of the substrate is, for example, as follows, based on the material of the substrate.

In the case of Si, uses include semiconductor memories, stacking of LSIs, CMOS image sensors, MEMS sealing, optical devices, and LEDs.

In the case of $SiO_2$, uses include semiconductor memories, stacking of LSIs, MEMS sealing, microflow channels, CMOS image sensors, optical devices, and LEDs.

In the case of PDMS, uses include microflow channes.

In the case of InGaAlAs, InGaAs, and InP, uses include optical devices.

In the case of InGaAlAs, GaAs, and GaN, uses include LEDs.

The thickness of the substrate is preferably from 0.5 $\mu$m to 1 mm, more preferably from 1 $\mu$m to 900 $\mu$m, and

still more preferably from 2 μm to 900 μm.

The shape of the substrate is not particularly limited. For example, in a case in which the substrate is a silicon substrate, the substrate may be a silicon substrate on which an interlayer insulating layer (Low-k film) is formed, and the silicon substrate may have minute grooves (recess portions), minute through-holes, or the like formed on/in the silicon substate.

For example, the laminated body according to the present disclosure may be produced using a method of producing a laminated body including a step of applying the composition for forming a film for a semiconductor according to the present disclosure to a surface of a substrate. The method of producing a laminated body may include, if necessary, a step of heating and/or drying the composition for forming a film for a semiconductor that has been applied to the substrate, after the step of applying the composition for forming a film for a semiconductor.

Examples of the method used for applying the composition for forming a film for a semiconductor according to the present disclosure to a surface of a substrate include a vapor-phase film forming method such as deposition polymerization, the CVD (Chemical Vapor Deposition) method, or the ALD (Atomic Layer Deposition) method, and a coating method such as a dipping method, a spraying method, a spin-coating method, or a bar-coating method. In the case of applying the composition for forming a film for a semiconductor using a coating method, it is preferable to apply the composition for forming a film for a semiconductor in a solution state. For example, use of a bar coating method is preferable in the case of forming a film having a micron-size film thickness, and use of a spin-coating method is preferable in the case of forming a film having a nano-size (from several nanometers to several hundreds of nanometers) film thickness. The film thickness of the composition for forming a film for a semiconductor may be adjusted, as appropriate, in accordance with the desired thickness of the joining layer.

For example, the method used for applying the composition for forming a film for a semiconductor by spin coating is not particularly limited, and, for example, a method may be used which includes dropping the composition for forming a film for a semiconductor onto a surface of a substrate while the substrate is rotated by a spin coater, and then increasing the revolving speed of the substrate so as to dry.

In the method used for applying the composition for forming a film for a semiconductor by spin coating, conditions such as the revolving speed of the substrate, the viscosity of the composition for forming a film for a semiconductor, the dropping amount and dropping time, and the revolving speed of the substrate during drying are not particularly limited, and may be adjusted, as appropriate, in consideration of, for example, the thickness of the composition for forming a film for a semiconductor to be deposited.

The substrate to which the composition for forming a film for a semiconductor has been applied may be washed in order to remove an excessive portion of the applied composition for forming a film for a semiconductor. Examples of washing methods include a wet rinsing with a rinse liquid such as a polar solvent, and plasma cleaning.

<Electrode Formation 1>

The substrate may have an electrode on a surface to which the composition for forming a film for a semiconductor is to be applied. For example, an electrode may be formed on a surface of the substrate to which the composition for forming a film for a semiconductor is to be applied, before the composition for forming a film for a semiconductor is applied to the substrate.

The electrode may be formed as a protrusion on a surface of the substrate, or formed in a state penetrating through the substrate, or formed in a state of being embedded in the substrate.

In a case in which the substrate has an electrode on a surface to which the composition for forming a film for a semiconductor is to be applied, and in which the composition for forming a film for a semiconductor is applied to the surface of the substrate that has the electrode, the electrode is preferably formed as a protrusion on the surface of the substrate. In a case in which an electrode is provided on a substrate surface but in which the composition for forming a film for a semiconductor is not applied to the surface of the substrate that has the electrode, the electrode on the substrate surface may be in any shape.

<Electrode Formation 2>

After a joining layer is formed on a surface, an electrode may be formed at a surface at which the joining layer has been formed. For example, a hole, in which an electrode is to be formed, may be formed in the joining layer by dry etching, and an electrode may be formed in the hole.

<Electrode Formation 3>

In a case in which the composition for forming a film for a semiconductor has photosensitivity, a hole, in which an electrode is to be formed, may be formed by photolithography in the composition for forming a film for a semiconductor

that has been applied to the substrate, and the composition for forming a film for a semiconductor may be subjected, if necessary, to, for example, drying and/or heating, thereby forming a joining layer. After this step, an electrode may be formed in the prepared hole.

Examples of the material of the electrode include copper, solder, tin, gold, silver, and aluminum.

In the electrode formation 1, electrode formation 2, and electrode formation 3 described above, examples of the method used for forming an electrode include electroplating, electroless plating, sputtering, and ink-jetting.

In a case in which the composition for forming a film for a semiconductor is provided on an electrode, the composition for forming a film for a semiconductor that is present on the electrode may be removed. As a result of this, the composition for forming a film for a semiconductor that has been applied to an electrode surface is removed, to allow the electrode to be exposed. Examples of the method used for removing the composition for forming a film for a semiconductor that has been applied to the electrode surface include fly cutting, Chemical Mechanical Polishing (CMP), and plasma dry etching. One removal method may be used singly, or two or more removal methods may be used together. For example, a surface planar (DFS8910 (manufactured by DISCO Corporation)) or the like may be used in fry cutting. In the case of using CMP, the slurry to be used may be, for example, a slurry containing silica or alumina which is commonly used for polishing of a resin, or a slurry containing hydrogen peroxide and silica which is commonly used for polishing of metal. In the case of using plasma dry etching, fluorocarbon plasma, oxygen plasma, or the like may be used.

In the case of having removed the joining layer on an electrode surface to allow the electrode to be exposed, treatment of reducing an oxide on the electrode surface may be carried out, if necessary. Examples of reduction treatment methods include a method including heating the substrate at a temperature of from 100 °C to 300 °C in an acid atmosphere of, for example, formic acid, and a method of heating the substrate in a hydrogen atmosphere.

(Joining Layer)

In the laminated body according to the present disclosure, the joining layer formed on the substrate may be in an uncured state, a semi-cured state, or a cured state. The curing state of the joining layer may be regulated by the degree of drying and/or heating the composition for forming a film for a semiconductor that has been applied to the substrate.

In the laminated body according to the present disclosure, the joining layer may be in a cured state. For example, a cured joining layer may be formed by, for example, heating the composition for forming a film for a semiconductor that has been applied to a surface of the substrate. Heating conditions for forming a cured joining layer are described below.

The heating temperature of the composition for forming a film for a semiconductor that has been applied to a surface of the substrate is preferably from 100 °C to 450 °C, more preferably from 150 °C to 450 °C, and still more preferably from 180 °C to 400 °C.

The temperature noted above refers to the temperature of the surface of the composition for forming a film for a semiconductor that has been applied to the surface of the substrate.

Heating the composition for forming a film for a semiconductor causes removal of solvent contained in the composition for forming a film for a semiconductor. Further, components in the composition for forming a film for a semiconductor react to yield a cured product, thereby forming a joining layer including the cured product.

The pressure at which the composition for forming a film for a semiconductor is heated is not particularly limited, and is preferably greater than absolute pressure 17 Pa and smaller than or equal to the atmospheric pressure.

The absolute pressure is preferably greater than or equal to 1000 Pa and smaller than or equal to the atmospheric pressure, more preferably greater than or equal to 5000 Pa and smaller than or equal to the atmospheric pressure, and particularly preferably greater than or equal to 10000 Pa and smaller than or equal to the atmospheric pressure.

The heating of the composition for forming a film for a semiconductor may be carried out by an ordinary method using an oven or a hot plate. Examples of ovens that can be used include SPX-1120 manufactured by APPEX Corporation and VF-1000LP manufactured by Koyo Thermosystems Co., Ltd.

Further, the heating of the composition for forming a film for a semiconductor may be carried out in the atmospheric air or in an inert gas (such as nitrogen gas, argon gas, or helium gas) atmosphere.

The heating time for the composition for forming a film for a semiconductor that has been applied to a surface of the substrate is not particularly limited, and is, for example, 3 hours or less, and is preferably 1 hour or less. There are no particular restrictions regarding the lower limit of the heating time, and the lower limit may be, for example, 5 minutes.

The composition for forming a film for a semiconductor that has been applied to a surface of the substrate may be irradiated with ultraviolet light (UV), for the purpose of shortening the heating time. As the ultraviolet light, a ultraviolet light having a wavelength of from 170 nm to 230 nm, an excimer light having a wavelength of 222 nm, an excimer light having a wavelength of 172 nm, and the like are preferable. The UV irradiation is preferably performed in an inert gas atmosphere.

Whether the composition for forming a film for a semiconductor is in a cured state or not may be ascertained, for example, by measuring a peak intensity of a particular bond or structure by means of Fourier Transform Infrared

Spectroscopy (FT-IR). The particular bond or structure may be, for example, a bond or structure generated by a cross-linking reaction.

For example, formation of an amide bond, an imide bond, or the like is considered to indicate that the composition for forming a film for a semiconductor is in a cured state, and a peak intensity derived from such a bond, structure or the like may be checked by measuring with FT-IR.

An amide bond can be ascertained by the presence of oscillation peaks at about 1650 $cm^{-1}$ and about 1520 $cm^{-1}$.

An imide bond can be ascertained by the presence of oscillation peaks at about 1770 $cm^{-1}$ and about 1720 $cm^{-1}$.

The surface of the cured joining layer may be planarized. Examples of planarizing methods include fly cutting and Chemical Mechanical Polishing (CMP). One planarizing method may be used singly, or two or more planaziring methods may be used together.

The joining layer formed on the substrate preferably has functional groups capable of forming chemical bonds on a surface of the joining layer that is located at a side opposite to the substrate, from the viewpoint of increasing the joining strength between the substrate and another member such as another substrate. Examples of such functional groups include amino groups, epoxy groups, vinyl groups, and silanol groups (Si-OH groups), and silanol groups are preferable from the standpoint of heat resistance. These functional groups may be provided by surface treatment after the joining layer is formed, or may be provided by treatment with a silane coupling agent or the like. Alternatively, a compound containing such a functional group may be mixed in the composition for forming a film for a semiconductor.

Whether the surface of the joining layer has silanol groups or not can be assessed by surface analysis of the joining layer by means of Time-of-Flight Secondary Ion Mass Spectroscopy (TOF-SIMS). Specifically, whether the surface of the joining layer has silanol groups or not can be assessed based on the presence or absence of a peak at a mass-to-charge ratio (m/z) of 45, using PHI nanoTOFII (manufactured by UL VAC-PHI Incorporated), which is a TOF-SIMS instrument.

The thickness of the joining layer is preferably from 0.001 μm to 8.0 μm, more preferably from 0.01 μm to 6.0 μm, and still more preferably from 0.03 μm to 5.0 μm. When the thickness of the joining layer is greater than or equal to 0.001 μm, the joining strength for joining the substrate to another member via the joining layer can be increased. When the thickness of the joining layer is smaller than or equal to 8.0 μm, the variations in the thickness of the joining layer upon provision of the joining layer on a large-area substrate can be reduced.

In a case in which an electrode is provided on the joining-layer side surface of the substrate, the thickness of the joining layer is preferably from 0.01 μm to 8.0 μm, more preferably from 0.03 μm to 6.0 μm, and still more preferably from 0.05 μm to 5.0 μm, from the viewpoint of improving the joining strength and reducing variations in the thickness of the joining layer.

In a case in which an electrode is not provided on the joining-layer side surface of the substrate, the thickness of the joining layer is preferably greater than or equal to 0.001 μm and less than 1.0 μm, more preferably from 0.01 μm to 0.8 μm, and still more preferably from 0.03 μm to 0.6 μm, from the viewpoint of improving the joining strength and reducing variations in the thickness of the joining layer.

In the joining layer, each of the content of sodium and the content of potassium is preferably 10 ppb by mass or less on elemental basis. When the content of sodium and the content of potassium are each 10 ppb by mass or less on elemental basis, occurrence of defects in electrical properties of a semiconductor device, such as malfunction of a transistor, can be reduced.

[Substrate Laminated Body]

A substrate laminated body according to the present disclosure includes a first substrate, a joining layer formed from the composition for forming a film for a semiconductor according to the present disclosure, and a second substrate, which are layered in this order. In the substrate laminated body according to the present disclosure, the first substrate and the second substrate are joined via the joining layer formed from the composition for forming a film for a semiconductor described above. This configuration reduces misalignment of substrate positions at the time of joining the first substrate and the second substrate.

The substrate laminated body according to the present disclosure may be formed, for example, by joining the above-described laminated body according to the present disclosure, which includes a substrate as the first substrate and a joining layer, and a second substrate to each other via the joining layer.

(First Substrate and Second Substrate)

Preferable materials and configurations of the first substrate and the second substrate are not particularly limited, and may be the same as the preferable materials and configurations of the substrate to be used in the above-described laminated body according to the present disclosure. The materials and configurations of the first substrate and the second substrate may each independently be the same or different. The first substrate and the second substrate

may have an electrode on a surface to which the composition for forming a film for a semiconductor is to be applied, or on a surface that is located at a side facing the joining layer. Preferable configurations of the electrode are the same as the preferable configurations of an electrode in the above-described laminated body according to the present disclosure.

As described above, the substrate preferably includes at least one element selected from the group consisting of Si, Al, Ti, Zr, Hf, Fe, Ni, Cu, Ag, Au, Ga, Ge, Sn, Pd, As, Pt, Mg, In, Ta, and Nb. In the laminated body according to the present disclosure, it is more preferable that at least one of the first and second substrates is a semiconductor substrate that includes at least one elements selected from the group consisting of Si, Ga, Ge, and As.

In the substrate laminated body according to the present disclosure, at least one of the first substrate or the second substrate may have, on a surface at a side opposite to the joining-layer side, another substrate layered thereon. Preferable materials for the other substrate are the same as the preferable materials for the first substrate and the second substrate. The material of the other substrate may be the same as or different from that of at least one of the first substrate or the second substrate.

(Joining Layer)

In the substrate laminated body according to the present disclosure, the joining layer disposed between the first substrate and the second substrate is preferably in a cured state. Preferable modes of the joining layer in the substrate laminated body according to the present disclosure are the same as the preferable modes of the joining layer in the above-described laminated body according to the present disclosure, and, therefore, description of the preferable modes is omitted.

The substrate laminated body according to the present disclosure may be prepared, for example, according to the following method. An example of a method of producing a substrate laminated body according to the present disclosure includes a step of applying the composition for forming a film for a semiconductor according to the present disclosure to a surface of at least one of a first substrate or a second substrate (hereinafter also referred to as the "first step"), and a step of joining the first substrate and the second substrate via the joining layer formed from the composition for forming a film for a semiconductor (hereinafter also referred to as the "second step").

Preferable modes of the first step are the same as the preferable modes of the method of applying the composition for forming a film for a semiconductor according to the present disclosure to a surface of a substrate described in relation to the above-described laminated body according to the present disclosure.

In the second step, the composition for forming a film for a semiconductor according to the present disclosure that has been applied to a surface of at least one of the first substrate or the second substrate may be subjected to heating or the like to form a joining layer that is at least partially cured, and then the first substrate and the second substrate may be joined via the joining layer; alternatively, the first substrate, the joining layer in an uncured state, and the second substrate may be layered in this order, and then the joining layer in an uncured state in the layers stack may be cured by heating or the like, to form the final joining layer.

The heating conditions for heating the composition for forming a film for a semiconductor that has been applied to a surface of at least one of the first substrate or the second substrate, and preferable heating conditions for heating the joining layer in an uncured state in the layers stack are each independently the same as the preferable heating conditions for the composition for forming a film for a semiconductor that has been applied to a surface of the substrate described in relation to the above-described laminated body according to the present disclosure.

In an example of the method of producing a substrate laminated body according to the present disclosure, a step of providing at least one type of functional group selected from the group consisting of a hydroxy group, an epoxy group, a carboxy group, an amino group, and a mercapto group by performing surface treatment on a face of at least one of the first substrate or the second substrate that is at a side to be contacted with the joining layer, preferably a face of the first substrate and a face of the second substrate each of which is at a side to be contacted with the joining layer (also referred to as "surface treatment step") may further be included. The inclusion of this step tends to enhance the joining strength between the substrates.

It should also be noted that, in the laminated body according to the present disclosure, a face of the substrate that is at a side to be contacted with the joining layer may be subjected to the surface treatment.

Examples of the surface treatment include plasma treatment, treatment with a chemical, and ozone treatment such as UV ozone treatment.

Hydroxy groups can be provided on a surface of the first substrate and a surface of the second substrate, by performing surface treatment, such as plasma treatment, treatment with a chemical, or ozone treatment such as UV ozone treatment, on the surface of the first substrate and the surface of the second substrate, respectively.

Hydroxy groups are preferably present in the state of binding to at least one element selected from the group consisting of Si, Al, Ti, Zr, Hf, Fe, Ni, Cu, Ag, Au, Ga, Ge, Sn, Pd, As, Pt, Mg, In, Ta, and Nb contained in the first or second substrate. In particular, it is more preferable that a face of at least one of the first substrate or the second substrate that is at a side to be provided with the joining layer has silanol groups, which include hydroxy groups.

Epoxy groups can be provided on a surface of the first substrate and a surface of the second substrate, by performing surface treatment, such as silane coupling with epoxy silane, on the surface of the first substrate and the surface of the second substrate, respectively.
Carboxy groups can be provided on a surface of the first substrate and a surface of the second substrate, by performing surface treatment, such as silane coupling with carboxysilane, on the surface of the first substrate and the surface of the second substrate, respectively.
Amino groups can be provided on a surface of the first substrate and a surface of the second substrate, by performing surface treatment, such as silane coupling with aminosilane, on the surface of the first substrate and the surface of the second substrate, respectively.
Mercapto groups can be provided on a surface of the first substrate and a surface of the second substrate, by performing surface treatment, such as silane coupling with mercaptosilane, on the surface of the first substrate and the surface of the second substrate, respectively.
In a case in which both of the first substrate and the second substrate have a joining layer formed thereon, the surface of at least one of the joining layers may be subjected to the above-described surface treatment, with a view to increasing the joining strength of the substrate laminated body.
With a view to increasing the joining strength of the substrate laminated body, a primer such as a silane coupling agent may be provided as a film on a face of at least one of the first substrate or the second substrate to which the composition for forming a film for a semiconductor is to be applied. In a case in which both of the first substrate and the second substrate have a joining layer formed thereon, a primer such as a silane coupling agent may be provided as a film on a face of at least one of the joining layers.
In an example of the method of producing a substrate laminated body according to the present disclosure, a step of subjecting at least one of the first substrate or the second substrate to a thinning processing (back-grinding or rear face grinding) after the second step may further be included, if necessary.
In an example of the method of producing a substrate laminated body according to the present disclosure, a step of performing dicing processing so as to divide the substrate into individual pieces may be included after the second step, if necessary. In the dicing processing, a dicer (DAD6340 (manufactured by DISCO Corporation)), for example, may be used.

(Examples of Multilayer Structure of Substrate Laminated Body)

Examples of multilayer structures of substrate laminated bodies for some applications are shown below:

For MEMS packaging: Si/Joining Layer/Si, $SiO_2$/Joining Layer/Si, $SiO_2$/Joining Layer/$SiO_2$, Cu/Joining Layer/Cu,
For microflow channels: PDMS/Joining Layer/PDMS, PDMS/Joining Layer/$SiO_2$,
For CMOS image sensors: $SiO_2$/Joining Layer/$SiO_2$, Si/Joining Layer/Si, $SiO_2$/Joining Layer/Si,
For through silicon vias (TSVs): $SiO_2$(Provided with Cu electrode)/Joining Layer/$SiO_2$(Provided with Cu electrode), Si(Provided with Cu electrode)/Joining Layer/Si(Provided with Cu electrode),
For optical devices: (InGaAlAs, InGaAs, InP, GaAs)/Joining Layer/Si,
For LEDs: (InGaAlAs, GaAs, GaN)/Joining Layer/Si,

(InGaAlAs, GaAs, GaN)/Joining Layer/$SiO_2$,
(InGaAlAs, GaAs, GaN)/Joining Layer/(Au, Ag, Al),
(InGaAlAs, GaAs, GaN)/Joining Layer/Sapphire

The substrate laminated body according to the present disclosure may include plural laminated bodies. For example, the substrate laminated body according to the present disclosure may be a substrate laminated body that includes a first stacked layer region and a second stacked layer region, and in which at least one of the first stacked layer region and at least one of the second stacked layer region are arranged in plane directions orthogonal to the layer-stacking direction, the first stacked layer region including the first substrate, the joining layer formed from the composition for forming a film for a semiconductor according to the present disclosure, and the second substrate, which are layered in this order, and the second stacked layer region including the first substrate, an electrode, and the second substrate, which are layered in this order. In other words, plural laminated bodies may be provided to be arranged in plane directions orthogonal to the layer-stacking direction, whereby a substrate laminated body in which plural stacked layer regions suited to the purpose are arranged can be obtained.
The substrate laminated body is allowed to not only include plural stacked layer regions arranged in plane directions, but also allowed to have a structure in which two or more laminated bodies are stacked in the layer-stacking direction.
For example, a substrate laminated body may be contemplated in which two or more sets each consisting of

the first stacked layer region are stacked in the layer-stacking direction, and in which two or more sets each consisting of the second stacked layer region are stacked in the layer-stacking direction.

A substrate laminated body suited to the desired three-dimensional substrate application may be obtained by arranging any number of laminated bodies in plane directions orthogonal to the layer-stacking direction of the laminated bodies as well as in the layer-stacking direction of the laminated bodies as described above, thereby enabling a wide range of applications for the substrate laminated body.

EXAMPLES

The present invention is more specifically described by reference to examples below. However, the examples illustrate an aspect of the present invention, and the invention is not limited to the examples.

In the examples, "%" refers to "% by mass" unless otherwise specified. In the descriptions below, ultrapure water (Milli-Q water manufactured by Millipore, having an electric resistance of 18 MΩ•cm or less (25 °C)) is used as water.

In Table 1, "-" indicates that no data were obtained.

[Example 1]

<Preparation of Composition for Forming Film for Semiconductor>

A composition for forming a film for a semiconductor was prepared. Details of the preparation were as described below.

Octamethylenediamine (diaminooctane, DAO) corresponding to the aliphatic diamine (A), 3-aminopropyl diethoxy methylsilane (3APDES) corresponding to the silane compound (B), and an asymmetric oxydiphthalic acid ethyl half-ester (aODAPehe) corresponding to the cross-linking agent (D) were prepared.

The aODAPehe was obtained by adding asymmetric oxydiphthalic anhydride (aODPA) to ethanol, and subjecting the mixture to reflux under heating for four hours until transparent liquid was obtained. Further, formation of an ester group in the prepared aODPAehe was confirmed by proton NMR. Ethanol was removed by using an evaporator, to prepare a liquid that had been concentrated to a half-ester compound concentration of from 70% to 75%, and this liquid was used as the cross-linking agent (D).

25 g of the silane compound (B) was dropwise added to 25 g of water, and dissolved to have a concentration of 50% by mass, and thereafter left to stand still overnight at room temperature. Thereafter, it was confirmed, based on proton NMR spectrum, that the ethoxysilane had been hydrolyzed. Then, the concentration of the silane compound (B) was adjusted to the concentration indicated in Table 1, by adding water to the silane compound (B)-containing liquid. Further, the silane compound (B)-containing was added to the aliphatic diamine (A) to provide the molar ratio indicated in Table 1, and then the cross-linking agent (D) was added, followed by stirring at room temperature overnight. In this way, a composition for forming a film for a semiconductor was prepared.

[Examples 2 to 6]

Compositions for forming a film for a semiconductor of Examples 2 to 6 were prepared in the same manner as that in Example 1, using the respective components to provide the molar ratio indicated in Table 1.

In Table 1, ODPAehe indicates symmetric oxydiphthalic acid ethyl half-ester, and the ODPAehe was prepared by allowing symmetric oxydiphthalic anhydride (ODPA) to react with ethanol. Ethanol was removed by using an evaporator, to prepare a liquid that had been concentrated to a half-ester compound concentration of from 70% to 75%, and this liquid was used as the cross-linking agent (D).

[Comparative Examples 1 to 3]

Compositions for forming a film for a semiconductor of Comparative Examples 1 to 3 were prepared in the same manner as that in Example 1, using the respective components to provide the molar ratio indicated in Table 1. In Table 1, BPDAehe indicates biphenyltetracarboxylic acid ethyl half-ester, and pXDA indicates paraxylylene diamine. The BPDAehe was prepared by allowing biphenyltetracarboxylic anhydride (BPDA) to react with ethanol. Ethanol was removed by using an evaporator, to prepare a liquid that had been concentrated to a half-ester compound concentration of from 70% to 75%, and this liquid was used as the cross-linking agent (D).

<Formation of Joining Layer>

Water was added to the composition obtained in each of the Examples and Comparative Examples so as to

adjust the concentration, for the purpose of forming a joining layer having the film thickness indicated in Table 1 by using the composition obtained in each of the Examples and the Comparative Examples. A 4-inch diameter silicon substrate (silicon wafer) was prepared as a substrate to which the composition after concentration adjustment was to be applied. After the silicon wafer was treated with UV (ultraviolet light) ozone for 5 minutes, the silicon wafer was placed on a spin coater, and about 5 mL of the composition after concentration adjustment was dropped on the silicon wafer. Then, after the silicon wafer was held in this state for 13 seconds, the silicon wafer was rotated at 2000 rpm (rpm representing the number of revolutions per minute) for 1 second, and then rotated at 600 rpm for 30 seconds, and then rotated at 2000 rpm for 10 seconds, for drying. After being left to stand still overnight, the silicon wafer was heated in an inert oven at 200 °C for 1 hour, thereby obtaining a cured joining layer.

In this process, the composition obtained in Comparative Example 3 gelated, and it was unable to form a film.

<Film Thickness of Joining Layer>

The film thickness of the joining layer formed on the silicon wafer was measured. Specifically, the film thickness was measured at the following positions, using a contact-type film thickness gauge: the center of the silicon wafer, a position that is 3 cm apart from the center of the silicon wafer toward the orientation flat, and a position that is 3 cm apart from the center of the silicon wafer in a direction away from the orientation flat. In Table 1, the average value of the film thicknesses at the three positions is indicated.

<Measurement of Residual Stress>

The residual stress $\sigma$ of the joining layer was calculated according to the following equation, based on the curvature X of the silicon wafer provided with the joining layer as measured using a laser-type warpage measurement apparatus DY-3000 (manufactured by Kohzu Precision Co., Ltd.) and curvature Y of the silicon wafer not provided with the joining layer that had been measured in advance.

$$\sigma = [E\times t^2/((1-\nu)\times 6\times t_{_film})](1/X-1/Y) \qquad \text{(Equation)}$$

A larger residual stress $\sigma$ value of the joining layer indicates that the warpage of the substrate is large, and that the positional misalignment is more likely to occur at the time of joining the substrates.

Here, in the equation, E represents the elastic modulus of the silicon wafer, t represents the thickness of the silicon wafer, v indicates the Poisson ratio of the silicon wafer, and $t_{_film}$ represents the thickness of the joining layer.

In Comparative Example 2, cracking of the joining layer occurred. Since this layer could not be used as a joining layer, calculation of residual stress was not carried out for Comparative Example 2.

The results are indicated in Table 1.

<Measurement of Surface Energy at Joining Interface>

Water and 1-propanol were added to the composition obtained in each of the Examples and Comparative Examples, to adjust the concentration such that the film thickness of the joining layer to be formed on the silicon wafer became about 1 μm. Using the composition after concentration adjustment, the joining layer was formed on a silicon wafer, which would serve as the first substrate, through the same procedures as those described above. The concentration of 1-propanol contained in the composition after concentration adjustment was 20% by mass. In the formation of the joining layer, drying of the coating film was carried out for 1 minute on a hot plate heated to 125 °C, instead of standing still overnight and drying.

A silicon wafer which would serve as the second substrate was attached at room temperature to the side of the joining layer obtained above having a thickness of about 1 μm for tentative fixing, followed by heating in an inert oven at 200 °C for 1 hour, whereby a substrate laminated body composed of the first substrate / the joining layer / the second substrate was prepared.

The surface energy (joining strength) of the joining interface in the substrate laminated body was measured by a blade insertion test according to the method described in non-patent document M. P. Maszara, G. Goetz, A. Cavigila, and J. B. Mckitterick, Journal of Applied Physics, 64 (1988) 4943-4950. A blade having a thickness of from 0.1 mm to 0.3 mm was inserted at the joining interface in the substrate laminated body, and the distance along which separation in the substrate laminated body occurred from the blade edge was measured using an infrared light source and an infrared camera. Thereafter, surface energy was determined based on the following equation.

$$\gamma = 3\times10^9\times t_b{}^2\times E^2\times t^6/(32\times L^4\times E\times t^3)$$

Here, $\gamma$ represents surface energy (J/m$^2$), $t_b$ represents the blade thickness (m), E represents the Young's modulus (GPa) of the silicon wafers included in the first substrate and the second substrate, t represents the thickness (m) of each of the first substrate and the second substrate, and L represents the distance (m) of separation of the substrate laminated body from the blade edge.
The results are indicated in Table 1.

<Measurement of Glass Transition Temperature>

In each of the Examples and Comparative Examples, the composition used for forming a joining layer for measuring residual stress was applied to a resin film, using an applicator at a gap of 250 $\mu$m, and was cured by being baked at 200 °C for 1 hour in nitrogen atmosphere. Subsequently, the cured film was peeled from the resin film, to obtain a self-standing film having a film thickness of from 10 $\mu$m to 70 $\mu$m.
The dynamic viscoelasticity properties of the self-standing film obtained above were measure using a dynamic viscoelasticity measurement apparatus RSA-III (manufactured by TA Instruments), and glass transition temperature was determined from the tan$\delta$ peak.
The results are indicated in Table 1.

| | Aliphatic Diamine (A) | Silane Compound (B) | Cross-linking Agent (D) | Other Amino-containing Component | Siloxane compound (A) | Silane Compound (B) | Cross-linking Agent (D) | Other Amino-containing Component | COOX/ Amino Groups | Film Thickness | Residual Stress | Surface Energy at Joining Interface | Glass Transition Temperature |
|---|---|---|---|---|---|---|---|---|---|---|---|---|---|
| | | | | | (Molar Ratio) | (Molar Ratio) | (Molar Ratio) | (Molar Ratio) | | (μm) | (MPa) | (J/m2) | (°C) |
| Example 1 | DAO | 3APDES | aODPAehe | Not Present | 0.25 | 1 | 0.75 | 0 | 2 | 12 | 19 | >2.5 | >100 |
| Example 2 | DAO | 3APDES | ODPAehe | Not Present | 0.25 | 1 | 0.75 | 0 | 2 | 14 | 21 | >2.5 | >100 |
| Example 3 | DAO | 3APDES | ODPAehe | Not Present | 0.5 | 1 | 1 | 0 | 2 | 11 | 15 | >2.5 | >100 |
| Example 4 | DAO | 3APDES | ODPAehe | Not Present | 4 | 1 | 4.5 | 0 | 2 | 22 | 11 | >2.5 | >100 |
| Example 5 | DAO | 3APDES | ODPAehe | Not Present | 2 | 1 | 2.5 | 0 | 2 | 18 | 12 | >2.5 | >100 |
| Example 6 | DAO | Not Present | ODPAehe | Not Present | 1 | 0 | 1 | 0 | 2 | 20 | 12 | >2.5 | <100 |
| Comparative Example 1 | Not Present | 3APDES | ODPAehe | Not Present | 0 | 1 | 0.5 | 0 | 2 | 2.7 | 25 | >2.5 | >100 |
| Comparative Example 2 | Not Present | 3APDES | BPDAehe | Not Present | 0 | 1 | 0.5 | 0 | 2 | 19 | Cracking | >2.5 | - |
| Comparative Example 3 | Not Present | 3APDES | ODPAehe | pXDA | 0 | 1 | 1 | 0.5 | 2 | - | - | - | - |

As demonstrated in Table 1, a joining layer with a reduced residual stress could be formed in Examples 1 to 6, as compared to Comparative Example 1, which did not contain the aliphatic diamine (A).

In particular, the glass transition temperatures in Examples 1 to 5 were higher than the glass transition temperature in Example 6, which did not contain the silane compound (B).

We surmise that cracking in Comparative Example 2 resulted from an excessively high residual stress of the joining layer.

The disclosure of Japanese Patent Application No. 2021-144612, filed September 6, 2021, is incorporated herein by reference.

All documents, patent applications, and technical standards mentioned in the present disclosure are incorporated herein by reference to the same extent as if each individual document, patent application, or technical standard was specifically and individually indicated to be incorporated by reference.

## Claims

**1.** A composition for forming a film for a semiconductor, comprising:

an aliphatic diamine (A) that includes at least one of a primary amino group or a secondary amino group, and a main chain including a carbon atom, wherein, in the aliphatic diamine (A), a total number of primary amino groups and secondary amino groups is 2 or greater, a number of carbon atoms of the main chain is from 2 to 180, and the aliphatic diamine (A) has a weight average molecular weight of from 60 to 2000; and

a cross-linking agent (D) that includes three or more -C(=O)OX groups in a molecule thereof (X representing a hydrogen atom or an alkyl group having from 1 to 6 carbon atoms), wherein from one to six of the three or more -C(=O)OX groups are -C(=O)OH groups, and the cross-linking agent (D) has a weight average molecular weight of from 200 to 2000.

**2.** The composition for forming a film for a semiconductor according to claim 1, further comprising a silane compound (B) that includes at least one of a primary amino group or a secondary amino group, and one or more silicon atoms, wherein, in the silane compound (B), the one or more silicon atoms and one or more non-polar groups, if any, bonded to the one or more silicon atoms satisfy a relationship, (non-polar groups)/Si $< 1.8$, as a molar ratio.

**3.** The composition for forming a film for a semiconductor according to claim 2, wherein a weight average molecular weight of the silane compound (B) is from 130 to 10000.

**4.** The composition for forming a film for a semiconductor according to claim 1 or claim 2, further comprising a siloxane compound (C) that is linear and includes at least one of a primary amino group or a secondary amino group, silicon atoms, and non-polar groups bonded to the silicon atoms, wherein, in the siloxane compound (C), a total number of primary amino groups and secondary amino groups is 2 or greater, and the silicon atoms and the non-polar groups bonded to the silicon atoms satisfy a relationship, (non-polar groups)/Si $\geq 1.8$, as a molar ratio.

**5.** The composition for forming a film for a semiconductor according to claim 4, wherein a weight average molecular weight of the siloxane compound (C) is from

**6.** The composition for forming a film for a semiconductor according to claim 1 or claim 2, wherein the aliphatic diamine (A) does not include a cyclic structure.

**7.** The composition for forming a film for a semiconductor according to claim 1 or claim 2, wherein amino group-containing components / cross-linking agent (D), which is a ratio of a content of the cross-linking agent (D) to a total content of components having an amino group contained in the composition for forming a film for a semiconductor, is greater than or equal to 0.1 and less than or equal to 10 as a molar ratio.

**8.** The composition for forming a film for a semiconductor according to claim 1 or claim 2, wherein COOX / amino groups, which is a ratio of a number of -C(=O)OX groups in molecules of the cross-linking agent (D) to a total number of amino groups of molecules of components having an amino group contained in the composition for forming a film for a semiconductor, is greater than or equal to 0.1 and less than or equal to 5.0.

**9.** The composition for forming a film for a semiconductor according to claim 1 or claim 2, wherein at least one X in the three or more -C(=O)OX groups in the cross-linking agent (D) is an alkyl group having from 1 to 6 carbon atoms.

**10.** The composition for forming a film for a semiconductor according to claim 1 or claim 2, wherein both ends of the main chain of the aliphatic diamine (A) are each independently a primary amino group or a secondary amino group.

**11.** A laminated body, comprising a joining layer formed from the composition for forming a film for a semiconductor according to claim 1 or claim 2, and a substrate, which are layered one on the other.

**12.** A substrate laminated body, comprising a first substrate, a joining layer formed from the composition for forming a film for a semiconductor according to claim 1 or claim 2, and a second substrate, which are layered in this order.

**13.** A substrate laminated body, comprising:

a first stacked-layer region including a first substrate, a joining layer formed from the composition for forming a film for a semiconductor according to claim 1 or claim 2, and a second substrate, which are layered in this order; and

a second stacked-layer region including a first substrate, an electrode, and a second substrate, which are layered in this order,

wherein at least one of the first stacked-layer region and at least one of the second stacked-layer region are arranged in a plane direction that is orthogonal to a layer-stacking direction.

**14.** The substrate laminated body according to claim 13, wherein two or more sets each consisting of the first stacked-layer region are stacked in the layer-stacking direction, and two or more sets each consisting of the second stacked-layer region are stacked in the layer-stacking direction.

**15.** The substrate laminated body according to claim 12, wherein at least one of the first substrate or the second substrate is a semiconductor substrate that includes at least one element selected from the group consisting of Si, Ga, Ge, and As.

**INTERNATIONAL SEARCH REPORT**

International application No. **PCT/JP2022/032439**

**A. CLASSIFICATION OF SUBJECT MATTER**

***H01L 21/312***(2006.01)i; ***C08G 73/10***(2006.01)i
FI: H01L21/312 C; C08G73/10

According to International Patent Classification (IPC) or to both national classification and IPC

**B. FIELDS SEARCHED**

Minimum documentation searched (classification system followed by classification symbols)

H01L21/312; C08G73/10

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2017/086361 A1 (MITSUI CHEMICALS, INC.) 26 May 2017 (2017-05-26) paragraphs [0027]-[0046],[0081], [0082], [0149], [0195] | 1-11 |
| Y | paragraphs [0027]-[0046],[0081], [0082], [0149], [0195] | 4-5, 12-15 |
| Y | JP 2020-95111 A (HITACHI CHEMICAL CO., LTD.) 18 June 2020 (2020-06-18) paragraphs [0038]-[0040], [0056] | 4-5 |
| Y | JP 2019-206689 A (ASAHI KASEI CORP.) 05 December 2019 (2019-12-05) paragraphs [0033], [0146] | 4-5 |
| Y | WO 2020/085183 A1 (MITSUI CHEMICALS, INC.) 30 April 2020 (2020-04-30) paragraphs [0017]-[0021], [0125]-[0130], [0191], fig. 3 | 12-15 |
| Y | JP 2012-216836 A (MITSUBISHI CHEMICALS CORP.) 08 November 2012 (2012-11-08) paragraph [0017], fig. 1 | 14 |
| A | JP 9-040931 A (HITACHI CHEM. CO., LTD.) 10 February 1997 (1997-02-10) entire text, all drawings | 1-15 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **14 September 2022** | **27 September 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/032439**

| Patent document cited in search report | Publication date (day/month/year) | Patent family member(s) | Publication date (day/month/year) |
|---|---|---|---|
| WO 2017/086361 A1 | 26 May 2017 | US 2020/0347265 A1<br>paragraphs [0056]-[0081], [0119], [0120], [0256]-[0258], [0364]<br>EP 3379564 A1<br>TW 201728686 A<br>KR 10-2018-0069876 A<br>CN 108292604 A | |
| JP 2020-95111 A | 18 June 2020 | (Family: none) | |
| JP 2019-206689 A | 05 December 2019 | TW 202003637 A | |
| WO 2020/085183 A1 | 30 April 2020 | US 2021/0391292 A1<br>paragraphs [0050]-[0064], [0212]-[0220], [0357], fig. 3<br>EP 3855477 A1<br>KR 10-2021-0060571 A<br>CN 112889131 A<br>TW 202037700 A | |
| JP 2012-216836 A | 08 November 2012 | US 2014/0027885 A1<br>paragraphs [0032]-[0034], fig. 1<br>EP 2693476 A1<br>TW 201250972 A<br>CN 103443919 A<br>KR 10-2014-0007429 A | |
| JP 9-040931 A | 10 February 1997 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H4132258 A
- JP 2010226060 A
- JP 2016047895 A
- JP S438828 B
- JP 49033120 B
- JP 20012123958 A
- WO 2010137711 A
- JP H6016809 A
- JP 2021144612 A


### Non-patent literature cited in the description


- **M. P. MASZARA ; G. GOETZ ; A. CAVIGILA ; J. B. MCKITTERICK.** *Journal of Applied Physics,* 1988, vol. 64, 4943-4950